# EUROPEAN PATENT SPECIFICATION

(11) **EP 4 231 339 B1**
(45) Date of publication and mention of the grant of the patent: **16.07.2025**
(21) Application number: 21946243.9
(22) Date of filing: 28.12.2021
(51) Int. Cl.: H01L 21/68, H01L 21/67, H01L 23/00

(54) **BONDING SYSTEM AND BONDING METHOD**
VERBINDUNGSSYSTEM UND VERBINDUNGSVERFAHREN
SYSTÈME DE LIAISON ET PROCÉDÉ DE LIAISON

(30) Priority: 24.12.2021 CN 202111594630
(43) Date of publication of application: 23.08.2023
(73) Proprietor: HUBEI 3D SEMICONDUCTOR INTEGRATED INNOVATION CENTER CO., LTD., Wuhan, Hubei 430000 (CN); Hubei Yangtze Memory Laboratories, Wuhan, Hubei 430000 (CN)
(72) Inventor: TIAN, Yingchao, Wuhan, Hubei 430000 (CN); LIU, Tianjian, Wuhan, Hubei 430000 (CN); CAO, Ruixia, Wuhan, Hubei 430000 (CN); ZHANG, Wei, Wuhan, Hubei 430000 (CN)
(74) Representative: Gevers Patents
(86) International application number: PCT/CN2021/142073
(87) International publication number: WO 2023/115614

(56) References cited:
- CN-A- 106 373 914
- CN-A- 107 665 847
- CN-A- 109 285 803
- JP-A- 2000 012 623
- JP-A- 2008 244 255
- JP-A- 2013 235 907
- KR-A- 20070 090 670
- US-A1- 2007 134 904
- US-A1- 2009 141 275
- US-A1- 2018 102 340
- US-A1- 2020 219 850
- US-A1- 2021 272 925

## Description

### CROSS-REFERENCE TO RELATED APPLICATIONS

This application is based on and claims priority from Chinese Patent Application No. 202111594630.2 filed on December 24, 2021 and entitled "BONDING SYSTEM AND BONDING METHOD".

### TECHNICAL FIELD

Embodiments of the present disclosure relate to, but are not limited to the field of semiconductor manufacturing, and in particular, to a bonding system and a bonding method.

### BACKGROUND

In the field of semiconductor manufacturing, three-dimensional (3D) integration of semiconductor devices may be implemented by using bonding technologies. Performance of chips may be improved by bonding two or more semiconductor structures with the same or different functions. Furthermore, metal interconnection between to-be-bonded objects may also be greatly shortened, thereby reducing heating, power consumption and delay.

Bonding processes may be distinguished by bonding objects, and include wafer to wafer bonding, die to wafer bonding and die to die bonding.

Related arts can be found in US 2007/134904 A1. US 2007/134904 A1 provides a die bonding apparatus and a bonding method are provided wherein the apparatus comprises a bond head movable between a supply of semiconductor dice and a die bonding site, a pick-up tool attached to the bond head for holding a die to be bonded at the die bonding site and an optical assembly positioned for viewing an orientation of the die bonding site. The bond head is configured such that an orientation of the die being held by the pick-up tool between the optical assembly and the die bonding site is viewable by the optical assembly, whereby the orientation of the die may be aligned with the orientation of the die bonding site.

### SUMMARY

The present invention is defined in the claims.

In the embodiments of the present disclosure, the offset of the picking surface of the bonding head with respect to the horizontal plane may be determined by providing the first alignment assembly, and the bonding assembly may drive, according to the offset, the bonding head to move to be parallel to the horizontal plane. That is, the picked die may be adjusted to be parallel to the horizontal plane before die to wafer bonding, which is conducive to reducing a probability of breakage of the die due to uneven local stress upon bonding and improving yield rate of die to wafer bonding.

After adjusting the die to be parallel to the horizontal plane, the first deviation value between the current position of the first to-be-bonded die and the first target position may also be determined by the first alignment assembly, the second deviation value between the current position of the second to-be-bonded die on the wafer and the second target position may be determined by providing the second alignment assembly, and the wafer or the first to-be-bonded die is adjusted according to the first deviation value and the second deviation value, which may align the first to-be-bonded die with the second to-be-bonded die accurately, and is conducive to improving accuracy of die to wafer bonding, and may further reduce difficulty of die to wafer bonding.

### BRIEF DESCRIPTION OF THE DRAWINGS

In order to explain specific implementations of the present disclosure or technical solutions in the related art more clearly, the drawings required to be used in descriptions of the specific implementations or the related art will be briefly introduced below. It is apparent that the drawings as described below are some implementations of the present disclosure, and other drawings may also be obtained by those ordinary skilled in the art according to these drawings without creative effort.
FIG. 1 shows a schematic view of a wafer to wafer bonding process according to an exemplary embodiment.
FIG. 2A shows a first schematic view of die to wafer bonding according to an exemplary embodiment.
FIG. 2B shows a second schematic view of die to wafer bonding according to an exemplary embodiment.
FIG. 3A shows a first schematic view of a bonding system according to an embodiment of the present disclosure.
FIG. 3B shows a first schematic view of an optical path of a bonding system according to an embodiment of the present disclosure.
FIG. 3C shows a second schematic view of an optical path of a bonding system according to an embodiment of the present disclosure.
FIG. 4A shows a second schematic view of a bonding system according to an embodiment of the present disclosure.
FIG. 4B shows a third schematic view of an optical path of a bonding system according to an embodiment of the present disclosure.
FIG. 5A shows a third schematic view of a bonding system according to an embodiment of the present disclosure.
FIG. 5B shows a fourth schematic view of an optical path of a bonding system according to an embodiment of the present disclosure.
FIG. 6 shows a fourth schematic view of a bonding system according to an embodiment of the present disclosure.
FIG. 7 shows a fifth schematic view of a bonding system according to an embodiment of the present disclosure.
FIG. 8 shows a sixth schematic view of a bonding system according to an embodiment of the present disclosure.
FIG. 9 shows a schematic flowchart of a bonding method according to an embodiment of the present disclosure.
FIG. 10A shows a first schematic process view of a bonding method according to an embodiment of the present disclosure.
FIG. 10B shows a second schematic process view of a bonding method according to an embodiment of the present disclosure.
FIG. 10C shows a third schematic process view of a bonding method according to an embodiment of the present disclosure.
FIG. 10D shows a fourth schematic process view of a bonding method according to an embodiment of the present disclosure.
FIG. 11 shows a schematic view of a die to wafer structure according to an embodiment of the present disclosure.

Reference numerals:
101 - Upper wafer; 102, 102' - Lower wafer; 201 - Upper die; 202 - Lower wafer; 300 - Bonding system; 11 - First to-be-bonded die / First die; 21 - Second to-be-bonded die / Second die; 20 - Wafer; 301 - Bonding head; 301a - Top surface; 301b - Picking surface; 301c - Side surface; 302, 302' - First optical path; 302a, 302a' - First end of first optical path; 302b, 302b' - Second end of first optical path; 3021 - First reflector; 303 - Wafer stage; 304, 304', 304" - First alignment assembly; 3041, 3041', 3041" - Aligner; 305 - Second alignment assembly; 306, 306', 306" - Second optical path; m₁ - First calibration mark; m₂ - Second calibration mark; m₃ - Third calibration mark; 3111 - First calibration optical path; 3111a - Right end of first calibration optical path; 3111b - Left end of first calibration optical path; 3112 - Second calibration optical path; 3112a - Right end of second calibration optical path; 3112b - Left end of second calibration optical path; 3042 - Transmission unit; 3043 - Receiving unit; 3061 - First sub-path; 3062 - Second sub-path; 3063 - Second reflector; 307 - Fixation unit; 308 - Mobile unit; 309 - Base; 310-1 - First bracket; 310-2 - Second bracket; 3041-1 - First aligner; 3041-2 - Second aligner; 302-1 - 1^{st} first optical path; 302-2 - 2^{nd} first optical path.

### DETAILED DESCRIPTION

The following embodiments are provided to understand the present disclosure better, and are not limited to best implementations, and do not limit contents and scope of protection of the present disclosure. Any product which is obtained by anyone under an inspiration of the present disclosure or by combining the present disclosure with features of other related art and is the same as or similar to the present disclosure falls within the scope of protection of the present disclosure.

In descriptions of the present disclosure, It is to be noted that terms indicating orientation or position relationships, such as "up", "down", "inside", "outside" or the like, are based on orientation or position relationships shown in the drawings, and are only intended to facilitate describing the present disclosure and simplify the descriptions, rather than indicating or implying that the referred device or element must have a specific orientation, and must be constructed and operated in a specific orientation, therefore they cannot be understood as limitation of the present disclosure. Furthermore, terms "first" and "second" are only for the purpose of descriptions, and cannot be understood as indicating or implying relative importance.

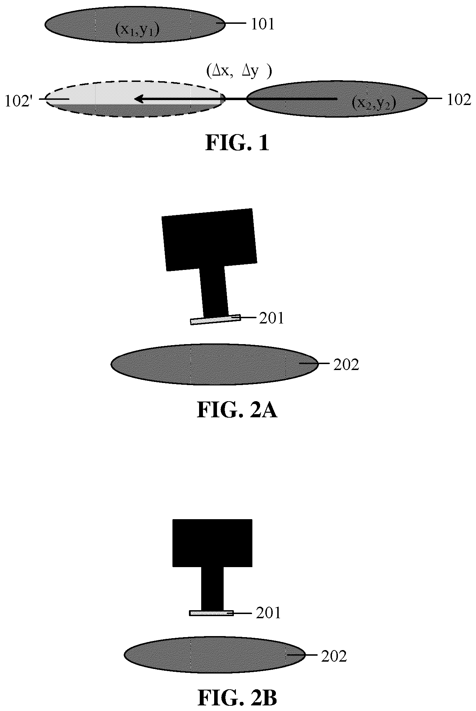

FIG. 1 shows a schematic view of a wafer to wafer bonding process according to an exemplary embodiment. With reference to FIG. 1, horizontal adjustment and visual alignment are required before bonding an upper wafer 101 to a lower wafer 102. Specifically, the horizontal adjustment includes adjusting the upper wafer 101 and the lower wafer 102 to be parallel to a horizontal plane respectively, and the visual alignment includes aligning the upper wafer 101 with the lower wafer 102 in a vertical direction perpendicular to the horizontal plane.

It is to be noted that since the wafer has a large size, a wafer stage carrying the wafer also has a large size. Generally, components may be integrated in the wafer stage to implement the horizontal adjustment and levelness detection of the wafer. For example, it may be implemented by components arranged in the wafer stage measuring height deviations among multiple positions on a surface of the wafer stage, which is simple and has a low accuracy requirement.

After adjusting the upper wafer 101 and the lower wafer 102 to be parallel to the horizontal plane respectively, a position of an alignment mark on a top surface of the lower wafer 102 is identified by using an upper lens located at a side of the upper wafer 101 away from the lower wafer 102, and is recorded as (x₂, y₂). A position of an alignment mark on a bottom surface of the upper wafer 101 is identified by using a lower lens located at a side of the lower wafer 102 away from the upper wafer 101, and is recorded as (x₁, y₁). A theoretical alignment deviation between the alignment mark on the bottom surface of the upper wafer 101 and the alignment mark on the top surface of the lower wafer 102 is (x₁ - x₂, y₁ - y₂).

It is to be noted that when the position of the alignment mark on the bottom surface of the upper wafer 101 is identified by using the lower lens, the lower wafer 102 is required to move away (for example, move the lower wafer from a position 102' to a position 102) to avoid the lower wafer 102 blocking a visual field of the lower lens. Similarly, when the position of the alignment mark on the top surface of the lower wafer 102 is identified by using the upper lens, the upper wafer 101 is required to move away to avoid the upper wafer 101 blocking a visual field of the upper lens.

Movement errors may also occur during the lower wafer or the upper wafer moving away. Specifically, during wafer to wafer bonding, since the wafer has a relatively large size, only the upper lens / the lower lens is required to be used to identify the position of the alignment mark of the lower wafer 102 / the upper wafer 101 respectively, and a last wafer movement error (Δx, Δy) is recorded, the movement error may be monitored according to a displacement deviation of an electrostatic chuck adsorbing the wafer. Therefore, an actual alignment deviation between the alignment mark on the bottom surface of the upper wafer 101 and the alignment mark on the top surface of the lower wafer 102 is (x₁ - x₂ + Δx, y₁ - y₂ + Δy). Correction and alignment are performed according to the actual alignment deviation, and the bottom surface of the upper wafer 101 is bonded to the top surface of the lower wafer 102.

Die to wafer bonding is different from wafer to wafer bonding. Specifically, in a wafer to wafer bonding process, a top bonding object is the wafer, while in a die to wafer bonding process, a top bonding object is the die, and the die has a size much less than that of the wafer. Therefore, a bonding device for die to wafer bonding is greatly different from a bonding device for wafer to wafer bonding. For example, receiving incoming materials, horizontal adjustment, visual alignment, downward bonding manner, or the like are different.

FIG. 2A and FIG. 2B show schematic views of die to wafer bonding according to an exemplary embodiment. With reference to FIG. 2A and FIG. 2B, horizontal adjustment and visual alignment are required before bonding an upper die 201 to a lower wafer 202. Specifically, the upper die 201 and the lower wafer 202 are adjusted to be parallel to a horizontal plane respectively, and then an alignment mark of the upper die 201 is aligned with an alignment mark of a to-be-bonded die in the lower wafer 202.

Compared with conventional wafer to wafer bonding, die to wafer bonding has a higher accuracy requirement and is more difficult to bond. In terms of horizontal adjustment, since the die has a size much less than that of the wafer, a bonding head picking the die also has a size much less than that of a component picking the wafer. Integrating more components in the bonding head will increase weight of the bonding head, leading to increase of inertia of the bonding head. Therefore, the horizontal adjustment and levelness detection of die to wafer bonding become a difficult problem. Furthermore, when the bonding head picking the die is not located at a horizontal position, a part of the die is very easy to be broken due to uneven stress, leading to failure of die to wafer bonding.

It is to be noted that since the lower wafer 202 and a wafer stage carrying the lower wafer 202 have large inertia, it is difficult for the lower wafer 202 to move with high frequency and high accuracy in the vertical direction. In order to meet a high frequency requirement of die to wafer bonding, the bonding head usually vertically moves downward to implement die to wafer bonding. Therefore, it is required to ensure that the bonding head is light enough to avoid excessive inertia.

In terms of visual alignment, during the upper die 201 moving to a position where it is aligned with the to-be-bonded die in the lower wafer 202, since the lower wafer 202 has a large blocking range for the lower lens, a displacement error generated by the upper chip 201 moving to the position where it is aligned with the to-be-bonded die in the lower wafer 202, is difficult to be identified and recorded by the lower lens, and die to wafer bonding has a low accuracy.

In view of this, the embodiments of the present disclosure provide a bonding system and a bonding method.

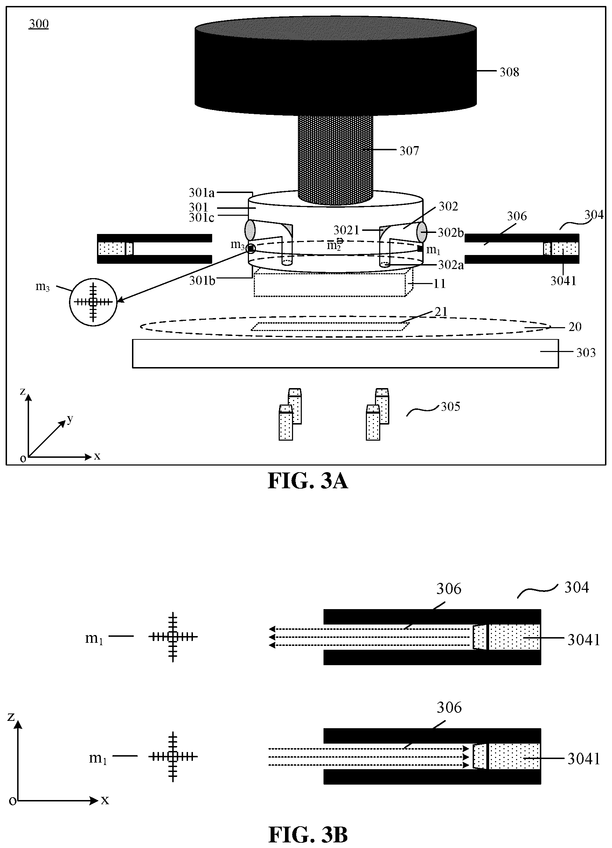

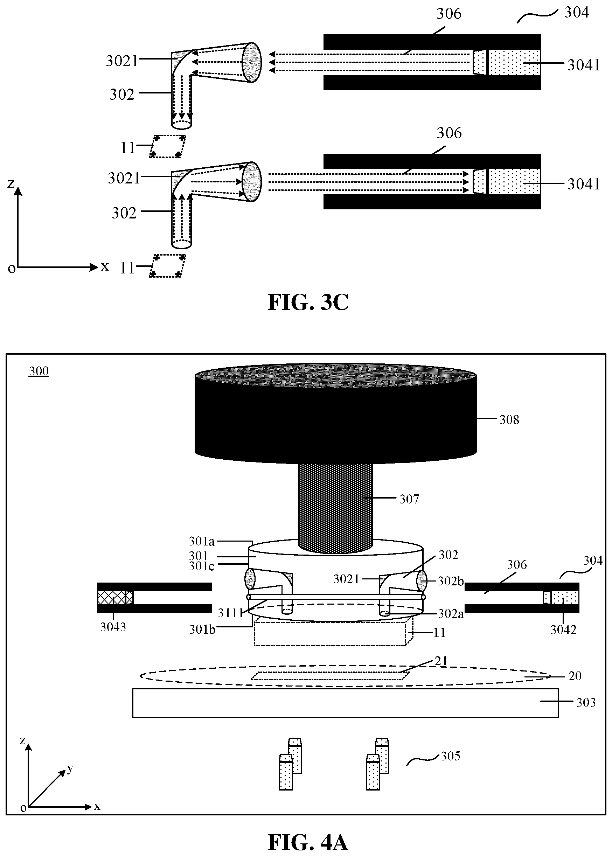

FIG. 3A to FIG. 3C show schematic views of a bonding system 300 according to an embodiment of the present disclosure, FIG. 3A represents a schematic structural view of the bonding system 300, FIG. 3B and FIG. 3C represent schematic views of a part of the bonding system 300. With reference to FIG. 3A, the bonding system 300 includes a bonding assembly, a wafer stage 303, a first alignment assembly 304, and a second alignment assembly 305.

The bonding assembly includes a bonding head 301 and a first optical path 302 penetrating the bonding head 301, here a first end 302a of the first optical path 302 is located at a picking surface 301b where the bonding head 301 picks a first to-be-bonded die 11.

The wafer stage 303 is configured to carry a wafer 20.

The first alignment assembly 304 is configured to determine an offset of the picking surface 301b with respect to a horizontal plane when the bonding head 301 is located at a first position.

The bonding assembly is further configured to drive, according to the offset, the bonding head 301 to move to a second position parallel to the horizontal plane.

The first alignment assembly 304 is further configured to transmit a detection optical signal to the first end 302a through a second end 302b of the first optical path 302 when the bonding head 301 is located at the second position, here the picked first to-be-bonded die 11 covers the first end 302a and reflects the detection optical signal.

The first alignment assembly 304 is further configured to receive a reflection optical signal generated by the first to-be-bonded die reflecting the detection optical signal 11, and determine a first deviation value between a current position of the first to-be-bonded die 11 and a first target position according to the received reflection optical signal.

The second alignment assembly 305 is located at a side of the wafer stage 303 away from the bonding assembly, and is configured to determine a second deviation value between a current position of a second to-be-bonded die 21 on the wafer 20 and a second target position.

The wafer stage 303 is further configured to drive, according to the first deviation value and the second deviation value, the carried wafer 20 to move relative to the picking surface 301b, to align the second to-be-bonded die 21 with the first to-be-bonded die 11; or the bonding assembly is further configured to drive, according to the first deviation value and the second deviation value, the picking surface 301b where the first to-be-bonded die 11 is picked to move relative to the wafer stage 303, to align the first to-be-bonded die 11 with the second to-be-bonded die 21.

The bonding assembly is further configured to bond the first to-be-bonded die 11 to the second to-be-bonded die 21.

Exemplarily, after the bonding head 301 of the bonding assembly picks the first to-be-bonded die 11, the bonding assembly may move in a horizontal direction (e.g., x direction or y direction) and/or a vertical direction (e.g., z direction) to adjust the bonding head 301 to the first position. Here, the first position represents a position of the bonding head 301 before levelness detection and horizontal adjustment.

When the bonding head 301 is located at the first position, the offset of the picking surface 301b with respect to the horizontal plane (e.g., an xoy plane) may be detected by using the first alignment assembly 304, and the offset may be expressed by an angle between the picking surface 301b and the horizontal plane, or by heights of multiple points on the picking surface 301b with respect to the same horizontal plane.

After determining the offset of the picking surface 301b with respect to the horizontal plane, the bonding assembly may drive the bonding head 301 to rotate until the picking surface 301b is parallel to the horizontal plane, and adjust the bonding head 301 to the second position. Here, the second position represents a position of the bonding head 301 after levelness detection and horizontal adjustment, where the second end 302b of the first optical path 302 may receive the detection optical signal transmitted by the first alignment assembly 304.

Exemplarily, with reference to FIG. 3A and FIG. 3C, the first alignment assembly 304 transmits the detection optical signal when the bonding head 301 is located at the second position, the detection optical signal is transmitted to a positioning mark of the first to-be-bonded die 11 through the second end 302b and the first end 302a of the first optical path 302, and forms the reflection optical signal, the reflection optical signal is transmitted to the first alignment assembly 304 through the first end 302a and the second end 302b of the first optical path 302.

Exemplarily, after receiving the reflection optical signal, the first alignment assembly 304 may determine the first deviation value (Δx_{T}, Δy_{T}) between the current position (x₁, y₁) of the first to-be-bonded die 11 and the first target position (x₀, y₀) according to the reflection optical signal, here Δx_{T} = x₁ - x₀, Δy_{T} = y₁ - y₀.

Exemplarily, with reference to FIG. 3A, the second deviation value (Δx_{B}, Δy_{B}) between the current position (x₂, y₂) of the second to-be-bonded die 21 on the wafer 20 and the second target position (x₀', y₀') may be determined by using the second alignment assembly 305, here Δx_{B} = x₂ - x₀', Δy_{T} = y₂ - y₀'.

It is to be noted that the first target position and the second target position have the same position in the horizontal direction, while have different positions in the vertical direction, that is, x₀ is the same as x₀', y₀ is the same as y₀', and the first target position and the second target position have different coordinates in the z direction. Different reference numerals are only intended to facilitate distinction between the first target position and the second target position, and are not intended to limit the present disclosure.

Here, the current position (x₁, y₁) of the first to-be-bonded die 11, the first target position (x₀, y₀), the current position (x₂, y₂) of the second to-be-bonded die 21 and the second target position (x₀', y₀') are determined based on the same coordinate system. For example, a coordinate system may be established by taking center of the wafer stage as an origin, x and y directions are perpendicular to each other and parallel to a plane where the wafer stage is located, and z direction is perpendicular to the plane where the wafer stage is located.

Before bonding a die to a wafer, a standard die may be used to calibrate positions of the first alignment assembly, the second alignment assembly and the bonding assembly, to ensure that the first alignment assembly may be aligned with the second end of the first optical path, and that the second alignment assembly may be aligned with a positioning mark on a surface of the standard die facing the wafer stage, thus determining the first target position and the second target position. Here, the first target position represents a position of the standard die after calibration, and coordinate in the horizontal direction is marked as (x₀, y₀); a position with a preset distance from the first target position in the vertical direction is marked as the second target position, coordinate of the second target position in the horizontal direction is marked as (x₀', y₀'), here the preset distance is greater than 0. It may be understood that although the first target position and the second target position have the same position in the horizontal direction (x and y directions), they are not the same position in a 3D space, and the first target position and the second target position have different positions in the vertical direction (z direction).

It may be understood that when the first to-be-bonded die is located at the first target position, and the second to-be-bonded die is located at the second target position, it may be considered that the first to-be-bonded die is aligned with the second to-be-bonded die. That is, a projection of the first to-be-bonded die on the wafer stage overlaps with the second to-be-bonded die in the vertical direction.

It is to be noted that the current position of the first to-be-bonded die 11 represents an actual position of the first to-be-bonded die 11 when the bonding assembly is adjusted to the second position, and may have a deviation with respect to the first target position. The current position of the second to-be-bonded die 21 represents an actual position of the second to-be-bonded die 21 when the wafer 20 is placed on the wafer stage and a die required to be bonded on the wafer is determined to be the second to-be-bonded die, and may have a deviation with respect to the second target position.

When the current position of the first to-be-bonded die 11 is the first target position and the current position of the second to-be-bonded die 21 is the second target position, each of the first deviation value and the second deviation value is 0. Accurate alignment and bonding between the first to-be-bonded die and the second to-be-bonded die may be implemented by the wafer vertically moving upward or the first to-be-bonded die vertically moving downward.

Exemplarily, a displacement deviation between the first to-be-bonded die 11 and the second to-be-bonded die 21 is determined to be (Δx_{T} - Δx_{B}, Δy_{T} - Δy_{B}) according to the first deviation value and the second deviation value. The bonding assembly may be kept fixed (that is, the first to-be-bonded die **11 is** kept fixed), and the wafer stage 303 drives the wafer 20 to move by (Δx_{T} - Ax_{B}, Δy_{T} - Δy_{B}) horizontally according to the displacement deviation, so that the second to-be-bonded die 21 is aligned with the first to-be-bonded die **11,** that is, positions of the first to-be-bonded die 11 and the second to-be-bonded die 21 in the horizontal direction are the same.

Here, a direction in which the wafer stage 303 drives the wafer 20 to move may be determined according to a positive or negative value of Δx_{T} - Δx_{B}. For example, when Δx_{T} - Δx_{B} is a negative value, the wafer stage 303 drives the wafer 20 to move in a negative direction of x-axis, and a movement distance is an absolute value of (Δx_{T} - Δx_{B}). When Δx_{T} - Δx_{B} is a positive value, the wafer stage 303 drives the wafer 20 to move in a positive direction of x-axis, and a movement distance is (Δx_{T} - Δx_{B}).

Similarly, a direction in which the wafer stage 303 drives the wafer 20 to move may be determined according to whether Δy_{T} - Δy_{B} is a positive or negative value. For example, when Δy_{T} - Δy_{B} is a negative value, the wafer stage 303 drives the wafer 20 to move in a negative direction of y-axis, and a movement distance is an absolute value of (Δy_{T} - Δy_{B}). When Δy_{T} - Δy_{B} is a positive value, the wafer stage 303 drives the wafer 20 to move in a positive direction of y-axis, and a movement distance is (Δy_{T} - ΔY_{B}).

Exemplarily, a displacement deviation between the first to-be-bonded die 11 and the second to-be-bonded die 21 is determined to be (Δx_{T} - Δx_{B}, Δy_{T} - Δy_{B}) according to the first deviation value and the second deviation value. The wafer stage 303 may be kept fixed (that is, the second to-be-bonded die 21 is kept fixed), and the bonding assembly moves by (Δx_{T} - Δx_{B}, Δy_{T} - Δy_{B}) horizontally according to the displacement deviation, so that the first to-be-bonded die **11** is aligned with the second to-be-bonded die 21.

Here, a direction in which the bonding assembly moves may be determined according to a positive or negative value of Δx_{T} - Δx_{B}. For example, when Δx_{T} - Δx_{B} is a negative value, the bonding assembly moves in a positive direction of x-axis, and a movement distance is an absolute value of (Δx_{T} - Δx_{B}). When Δx_{T} - Δx_{B} is a positive value, the bonding assembly moves in a negative direction of x-axis, and a movement distance is (Δx_{T} - Δx_{B}).

Similarly, a direction in which the bonding assembly moves may be determined according to a positive or negative value of Δy_{T} - Δy_{B}. For example, when Δy_{T} - Δy_{B} is a negative value, the bonding assembly moves in a positive direction of y-axis, and a movement distance is an absolute value of (Δy_{T} - Δy_{B}). When Δy_{T} - Δy_{B} is a positive value, the bonding assembly moves in a negative direction of y-axis, and a movement distance is (Δy_{T} - Δy_{B}).

In this example, after determining the first deviation value and the second deviation value, the first to-be-bonded die may be aligned with the second to-be-bonded die by driving the picking surface where the first to-be-bonded die is picked to move relative to the wafer stage, or by driving the carried wafer to move relative to the picking surface. Preferably, after determining the first deviation value and the second deviation value, the carried wafer is driven to move relative to the picking surface, to align the second to-be-bonded die with the first to-be-bonded die.

It is to be noted that the die and the bonding head picking the die have relatively small sizes. When the bonding assembly is made to move relative to the wafer, the small-sized bonding head is more likely to fluctuate during movement of the bonding assembly, and may incline relative to the horizontal plane, leading to inclination of the die picked by the bonding head, affecting alignment and reducing bonding accuracy.

Compared with a manner of alignment by moving the bonding assembly relative to the wafer, when the wafer is driven to move relative to the picking surface, since the wafer has a size greater than that of the die, there is a small probability of a bonding surface of the wafer fluctuating in the horizontal plane during movement of the wafer, that is, the second to-be-bonded die bonded with the first to-be-bonded die is more horizontal, which is conducive to further improving accuracy of die to wafer bonding.

The bonding head 301 may adsorb the first to-be-bonded die 11 by vacuum adsorption or electrostatic adsorption. The first to-be-bonded die 11 may include a bonding surface and a non-bonding surface arranged opposite to each other. During die to wafer bonding, the picking surface picks the first to-be-bonded die 11 by adsorbing the non-bonding surface of the first to-be-bonded die 11.

The first to-be-bonded die 11 includes semiconductor chips, such as memory chips, communication chips, artificial intelligence (AI) chips, light emitting diode (LED) chips, sensor chips, display chips, or the like. With reference to FIG. 3A, the first to-be-bonded die 11 includes a front side and a back side arranged opposite to each other in the z direction. When the front side of the first to-be-bonded die 11 is provided with functional structures, the front side of the first to-be-bonded die 11 is the bonding surface, and the back side of the first to-be-bonded die 11 is the non-bonding surface.

It is to be noted that the first to-be-bonded die 11, the wafer 20 and the second to-be-bonded die 21 are not included in the bonding system 300, and the first to-be-bonded die 11, the wafer 20 and the second to-be-bonded die 21 (shown in dash lines) are merely illustrative in FIG. 3A, to facilitate understanding position relationships among the to-be-bonded die, the bonding head and the wafer during die to wafer bonding.

The first optical path 302 includes the first end 302a and the second end 302b. The first end 302a is configured to output the detection optical signal and receive the reflection optical signal, and the second end 302b is configured to receive the detection optical signal and output the reflection optical signal. The first optical path 302 allows the detection optical signal and reflection optical signal to pass through, and may be a transparent window arranged in the bonding head 301, or an optical transmission medium arranged in the bonding head 301, such as an optical fiber or the like.

The first alignment assembly and the second alignment assembly may transmit the detection optical signal, may also receive the reflection optical signal, and may also convert the received reflection optical signal into a visual image. For example, the first alignment assembly may acquire a first image of a positioning mark on the first to-be-bonded die, and determine the first deviation value according to the first image. The second alignment assembly may acquire a second image of a positioning mark on the second to-be-bonded die, and determine the second deviation value according to the second image. The first alignment assembly and the second alignment assembly may transmit and receive infrared light signals (e.g., far infrared light signals).

The wafer stage 303 may include a chuck (not shown in the figure), such as an electrostatic chuck (ESC chuck), to adsorb the wafer 20.

In some embodiments, the wafer stage may move with respect to the picking surface, to drive the wafer to move with respect to the picking surface.

In some other embodiments, although a mesa of the wafer stage configured to carry the wafer is not movable itself, the wafer stage includes a lift pin which may move relative to the picking surface. The wafer may be driven to move relative to the picking surface by driving the lift pin to move relative to the picking surface, to implement position adjustment of the wafer. The lift pin may be provided with a vacuum hole to absorb the wafer through vacuum. The lift pin may move in a plane parallel to the wafer, to drive the wafer to move, so as to adjust the position of the wafer.

Specifically, the wafer stage including the ESC chuck is taken as an example, the ESC chuck includes a fixed substrate and a lift pin, the lift pin passes through the fixed substrate in an axial direction of the ESC chuck and may move in a direction perpendicular to the fixed substrate and a direction parallel to the fixed substrate. When the ESC chuck carries a wafer, the lift pin may contact the wafer. When the lift pin moves towards the picking surface in the direction perpendicular to the fixed substrate, the carried wafer is jacked up by the lift pin and thus separated from the fixed substrate, and the carried wafer moves with the lift pin.

The wafer 20 includes multiple second to-be-bonded die 21, each of the second to-be-bonded dies 21 includes a substrate and functional structures (such as a storage array or a functional circuit) on the substrate, and a cutting channel is arranged between two adjacent second to-be-bonded dies.

In the embodiments of the present disclosure, the offset of the picking surface of the bonding head with respect to the horizontal plane may be determined by providing the first alignment assembly, and the bonding assembly may drive, according to the offset, the bonding head to move to be parallel to the horizontal plane. That is, the picked die may be adjusted to be parallel to the horizontal plane before die to wafer bonding, which is conducive to reducing a probability of breakage of the die due to uneven local stress upon bonding and improving yield rate of die to wafer bonding.

After adjusting the die to the second position parallel to the horizontal plane, the first deviation value between the current position of the first to-be-bonded die and the first target position may also be determined by the first alignment assembly, the second deviation value between the current position of the second to-be-bonded die on the wafer and the second target position may be determined by providing the second alignment assembly, and position of the wafer or the first to-be-bonded die is adjusted according to the first deviation value and the second deviation value, which may align the first to-be-bonded die with the second to-be-bonded die accurately, and is conducive to improving accuracy of die to wafer bonding.

In some embodiments, with reference to FIG. 3A, the bonding head 301 may include a side surface 301c perpendicular to the picking surface 301b, a top surface 301a parallel to the picking surface 301b, and at least three calibration marks, here the at least three calibration marks are located on the side surface 301c or the top surface 301a, and a plane where the at least three calibration marks are located is parallel to the picking surface 301b.

The first alignment assembly 304 is specifically configured to determine the offset according to sub-deviations between the at least three calibration marks and a preset position.

Exemplarily, FIG. 3A shows calibration marks m₁, m₂ and m₃ on the side surface 301c, a plane composed of the calibration marks m₁, m₂ and m₃ is marked as a calibration plane which is parallel to the picking surface 301b. It may be understood that when the bonding head 301 is located at the first position, the offset of the picking surface 301b with respect to the horizontal plane may be determined by determining an offset of the calibration plane with respect to the horizontal plane.

Although only the calibration marks m₁, m₂ and m₃ on the side surface 301c are shown in this example, the calibration marks m₁, m₂ and m₃ may be located on the top surface 301a in other examples, for example, on a boundary line of the top surface 301a. The number of the calibration marks on the side surface 301c or the top surface 301a is not limited to three, there may also be four, five or more calibration marks, which are not limited here by the present disclosure.

Exemplarily, when the bonding head 301 is located at the first position, the first alignment assembly 304 may determine a position (xₘ₁, yₘ₁) of the first calibration mark m₁, a position (xₘ₂, yₘ₂) of the second calibration mark m₂ and a position (xₘ₃, yₘ₃) of the third calibration mark m₃ respectively, and may determine an offset of the calibration plane with respect to the horizontal plane according to height deviations between positions of the three calibration marks and the preset position, and thus determine the offset of the picking surface 301b with respect to the horizontal plane.

The first alignment assembly 304 includes a finder frame to determine positions of the calibration marks m₁, m₂ and m₃, here the preset position represents a central position of the finder frame and is marked as (x_{c}, y_{c}). It may be understood that when height deviations between the three calibration marks m₁, m₂ and m₃ and the preset position in the y-axis direction are the same, that is, when yₘ₁ - y_{c}, yₘ₂ - y_{c} and yₘ₃ - y_{c} have the same numeric value and the same positive or negative property, it may be determined that the calibration plane is parallel to the horizontal plane, and thus it may be determined that the picking surface parallel to the calibration plane is also parallel to the horizontal plane.

It is to be noted that when the bonding head 301 is located at the first position, the height deviation between position of each of the calibration marks and the preset position may be different. For example, when yₘ₁ - y_{c} < yₘ₂ - y_{c} < yₘ₃ - y_{c}, it may be determined that in a positive direction of z-axis, the position of the third calibration mark m₃ is higher than that of the second calibration mark m₂, and the position of the second calibration mark m₂ is higher than that of the first calibration mark m₁, that is, the calibration plane is inclined with respect to the horizontal plane, and the picking surface parallel to the calibration plane is also inclined with respect to the horizontal plane.

Exemplarily, when the calibration marks m₁, m₂ and m₃ are located below the second end 302b, the bonding assembly may adjust the bonding head 301 to a position parallel to the horizontal plane according to the offset, and then move the bonding head 301 in a negative direction of z-axis, to the second position where the second end 302b of the first optical path 302 may receive the detection optical signal transmitted by the first alignment assembly 304.

Similarly, when the calibration marks m₁, m₂ and m₃ are located above the second end 302b, the bonding assembly may adjust the bonding head 301 to a position parallel to the horizontal plane according to the offset, and then move the bonding head 301 in the positive direction of z-axis, to the second position where the second end 302b of the first optical path 302 may receive the detection optical signal transmitted by the first alignment assembly 304.

In some embodiments, with reference to FIG. 3A, when the at least three calibration marks are located on the side surface 301c, the first alignment assembly 304 is located on the side surface of the bonding head 301, and the second end 302b of the first optical path 302 is located on the side surface 301c. In other embodiments, when the at least three calibration marks are located on the top surface, the first alignment assembly is located above the bonding head, and the second end of the first optical path is located on the top surface.

It may be understood that the first alignment assembly may be arranged according to a manner of arranging the calibration marks on the bonding head, as long as it ensures that the first alignment assembly may detect the calibration marks. Similarly, the second end of the first optical path may also be arranged according to a manner of arranging the first alignment assembly, as long as it ensures that the first alignment assembly may be aligned with the first optical path. Reasonable arrangements may be made by those skilled in the art according to actual requirements, which are not further limited here by the present disclosure.

In the embodiments of the present disclosure, at least three calibration marks are arranged on the side surface or the top surface of the bonding head, a plane where three calibration marks are located is parallel to the picking surface, and the offset of the calibration plane with respect to the horizontal plane may be determined according to sub-deviations between the three calibration marks and the preset position, and thus the offset of the picking surface parallel to the calibration plane with respect to the horizontal plane is determined.

In some embodiments, with reference to FIG. 3A, the first alignment assembly 304 may be specifically configured to acquire a first image including a first calibration mark m₁ when the bonding head 301 is located at the first position, and determine a first sub-deviation between a position of the first calibration mark m₁ and the preset position according to the first image.

The bonding assembly is further configured to drive the bonding head 301 to rotate by a first angle, to enable the first alignment assembly 304 to acquire a second image including a second calibration mark m₂.

The first alignment assembly 304 is specifically further configured to determine a second sub-deviation between a position of the second calibration mark m₂ and the preset position according to the acquired second image.

The bonding assembly is further configured to drive the bonding head 301 to rotate by a second angle, to enable the first alignment assembly 304 to acquire a third image including a third calibration mark m₃.

The first alignment assembly 304 is specifically further configured to determine a third sub-deviation between a position of the third calibration mark m₃ and the preset position according to the acquired third image, and determine the offset according to the first sub-deviation, the second sub-deviation and the third sub-deviation.

Exemplarily, with reference to FIG. 3A and FIG. 3B, the first alignment assembly 304 may include an aligner 3041 located at a side of the bonding head 301. When the bonding head 301 is located at the first position, the aligner 3041 acquires the first image including the first calibration mark m₁, and determines the first sub-deviation (Δyₘ₁) between the position (xₘ₁, yₘ₁) of the first calibration mark m₁ and the preset position (x_{c}, y_{c}) according to the first image, Δyₘ₁ = yₘ₁ - y_{c}.

Exemplarily, with reference to FIG. 3A, the bonding assembly also includes a fixation unit 307, a mobile unit 308, and a driving unit (not shown in the figure) connected to the mobile unit 308. The fixation unit 307 fixedly connects the bonding head 301 to the mobile unit 308. The driving unit is configured to drive the mobile unit 308 to move the bonding head 301 relative to the wafer stage 303.

Exemplarily, the driving unit drives the mobile unit 308 to clockwise rotate by a first angle. When the mobile unit 308 rotates, the fixation unit 307, the bonding head 301 and the first to-be-bonded die 11 rotate synchronously, the aligner 3041 acquires the second image including the second calibration mark m₂, and determines the second sub-deviation (Δyₘ₂) between the position (xₘ₂, yₘ₂) of the second calibration mark m₂ and the preset position (x_{c}, y_{c}) according to the second image, Δyₘ₂ = yₘ₂ - y_{c}.

Then, the driving unit drives the mobile unit 308 to clockwise rotate by a second angle, the aligner 3041 acquires the third image including the third calibration mark m₃, and determines the third sub-deviation (Δyₘ₃) between the position (xₘ₃, yₘ₃) of the third calibration mark m₃ and the preset position (x_{c}, y_{c}) according to the third image, Δyₘ₃ = yₘ₃ - y_{c}. The offset of the picking surface with respect to the horizontal plane is determined according to Δyₘ₁, Δyₘ₂ and Δyₘ₃.

Here, the driving unit may also drive the mobile unit to rotate counter-clockwise, to ensure the aligner to rotate to be able to acquire the second image including the second calibration mark and the third image including the third calibration mark. Selections may be made by those skilled in the art according to actual bonding requirements, which are not further limited here by the present disclosure.

The first angle and the second angle may be determined according to a manner of providing the calibration marks m₁, m₂ and m₃. In a practical application, the bonding head may have a cylindrical shape, and each of the picking surface and the calibration plane may have a circular shape. The first angle may be determined based on a central angle formed by the calibration mark m₁, the calibration mark m₂ and center of the calibration plane, and the second angle may be determined based on a central angle formed by the calibration mark m₂, the calibration mark m₃ and the center of the calibration plane.

For example, when the calibration marks m₁, m₂ and m₃ may be arranged on the side surface 301c at equal intervals, each of the first angle and the second angle is 120°. When a line connecting the calibration marks m₁ and m₃ passes through the center of the calibration plane, and a line connecting the calibration mark m₂ and the center of the calibration plane is perpendicular to the line connecting the calibration marks m₁ and m₃, each of the first angle and the second angle is 90°.

In the embodiments of the present disclosure, the first image, the second image and the third image of the three calibration marks may be acquired sequentially by arranging the first alignment assembly, and the first sub-deviation, the second sub-deviation and the third sub-deviation may be determined sequentially according to the acquired first image, second image and third image, which is conducive to determining the offset of the picking surface with respect to the horizontal plane accurately.

In some embodiments, the first alignment assembly 304 may include at least three aligners 3041, each of the aligners 3041 is configured to acquire a sub-deviation between one of the calibration marks and the preset position.

The first alignment assembly 304 is specifically configured to determine the offset according to at least three sub-deviations.

Exemplarily, with reference to FIG. 3A, the first calibration mark m₁ and the third calibration mark m₃ are arranged in parallel along the x direction. The first alignment assembly 304 includes two aligners 3041 arranged in parallel along the x direction. The aligner 3041 at a right side of the bonding head 301 is configured to acquire the first sub-deviation between the first calibration mark m₁ and the preset position, and the aligner 3041 at a left side of the bonding head 301 is configured to acquire the third sub-deviation between the third calibration mark m₃ and the preset position. The first alignment assembly 304 also includes an aligner (not shown in the figure) at a side of the bonding head 301 facing the positive direction of y-axis, and configured to acquire the second sub-deviation between the second calibration mark m₂ and the preset position. The first alignment assembly 304 may determine the offset of the picking surface with respect to the horizontal plane according to the first sub-deviation, the second sub-deviation and the third sub-deviation.

It is to be noted that a scenario where the bonding head includes three calibration marks and the first alignment assembly includes three aligners, is shown in this example. In other examples, the bonding head may include at least four calibration marks, and the first alignment assembly may include at least four aligners. The number or positions of arranging the calibration marks in the bonding head are not limited here by the present disclosure, and it is only required to ensure that the plane where the calibration marks are arranged is parallel to the picking surface.

For example, based on what shown in FIG. 3A, the bonding head also includes two calibration marks arranged in parallel along the y direction, the first alignment assembly also includes two aligners arranged in parallel along the y direction, and second and fourth sub-deviations of the two calibration marks arranged in parallel along the y direction may be determined by the two aligners arranged in parallel along the y direction respectively. The first alignment assembly 304 may determine the offset of the picking surface with respect to the horizontal plane according to the first sub-deviation, the second sub-deviation, the third sub-deviation and the fourth sub-deviation.

Compared with arranging the first alignment assembly to acquire the first image, the second image and the third image of the three calibration marks sequentially, three aligners are arranged in the embodiments of the present disclosure, each aligner may acquire image of each calibration mark independently, without driving the bonding head to rotate, which is conducive to improving accuracy of three sub-deviations.

Furthermore, in the embodiments of the present disclosure, the three aligners may acquire images of the three calibration marks simultaneously, which may shorten the time for determining the offset, and thus shorten the time for levelness detection and horizontal adjustment before die to wafer bonding, improving bonding efficiency.

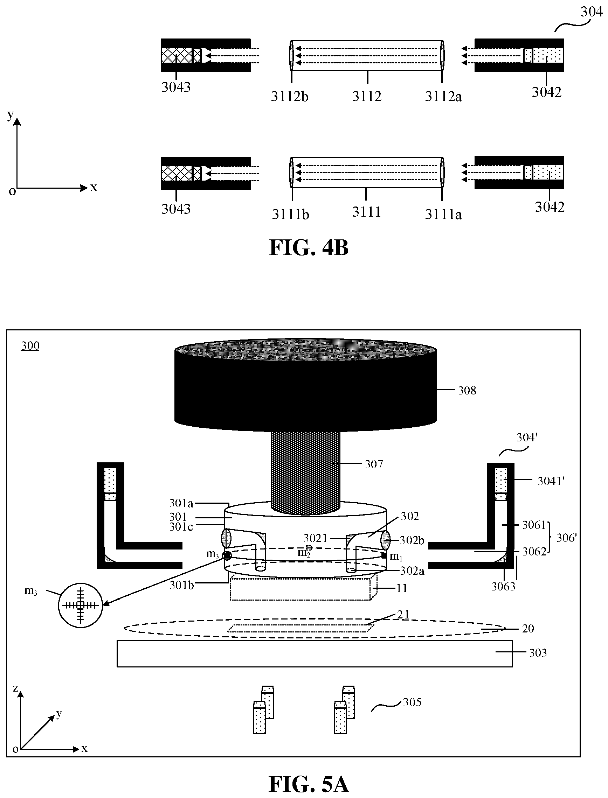

In some embodiments, with reference to FIG. 4A and FIG. 4B, the bonding head 301 may include a side surface 301c perpendicular to the picking surface 301b, and at least two calibration optical paths penetrating the bonding head 301 from the side surface 301c, here a plane where the at least two calibration optical paths are located is parallel to the picking surface 301b.

The first alignment assembly 304 is specifically configured to determine the offset according to sub-offsets between the at least two calibration optical paths and the horizontal plane.

Exemplarily, FIG. 4A shows a calibration optical path 3111 penetrating the bonding head 301 from the side surface 301c, and FIG. 4B shows two calibration optical paths 3111 and 3112 arranged in parallel along the y direction. It may be understood that projections of the two calibration optical paths 3111 and 3112 in an xoz plane coincide. Although only two calibration optical paths 3111 and 3112 are shown in this example, the number of calibration optical paths penetrating the bonding head 301 from the side surface 301c in other examples is not limited to two, there may be three or more calibration optical paths, which are not limited here by the present disclosure, and it is only required to ensure that the calibration optical paths do not overlap with the first optical path 302.

A plane formed by the two calibration optical paths 3111 and 3112 is marked as a calibration plane which is parallel to the picking surface 301b. It may be understood that when the bonding head 301 is located at the first position, the offset of the calibration plane with respect to the horizontal plane may be determined by the two calibration optical paths 3111 and 3112, and thus the offset of the picking surface 301b with respect to the horizontal plane is determined.

In some embodiments, with reference to FIG. 4A, the first alignment assembly 304 may include a transmission unit 3042 and a receiving unit 3043.

Here, when the bonding head 301 is located at the first position, the transmission unit 3042 is aligned with an end of a first calibration optical path, and the receiving unit 3043 is aligned with at least a part of area of another end of the first calibration optical path; the transmission unit 3042 is configured to transmit a calibration optical signal to the end of the first calibration optical path; the receiving unit 3043 is configured to determine a first sub-offset according to a received calibration optical signal transmitted through the first calibration optical path.

The bonding assembly is further configured to drive the bonding head 301 to rotate, to enable an end of a second calibration optical path to be aligned with the transmission unit 3042, here the receiving unit 3043 is aligned with at least a part of area of another end of the second calibration optical path.

The transmission unit 3042 is further configured to transmit a calibration optical signal to the end of the second calibration optical path; the receiving unit 3043 is further configured to determine a second sub-offset according to a received calibration optical signal transmitted through the second calibration optical path.

The first alignment assembly 304 is specifically configured to determine the offset according to the first sub-offset and the second sub-offset.

FIG. 4B shows a first calibration optical path 3111 and a second calibration optical path 3112 arranged in parallel along the y direction, and the transmission unit 3042 and the receiving unit 3043 are located at two sides of the first calibration optical path 3111 which are arranged opposite to each other in the x direction respectively. For example, the transmission unit 3042 is located at a right or left side of the first calibration optical path 3111, and the receiving unit 3043 is located at a left or right side of the first calibration optical path 3111.

When the bonding head 301 is located at the first position, the transmission unit 3042 is aligned with a right end 3111a of the first calibration optical path 3111. When the calibration optical signal transmitted by the transmission unit 3042 is a parallel beam, the calibration optical signal completely enters into the right end 3111a, that is, intensity of the calibration optical signal transmitted by the transmission unit 3042 is substantially the same as that of the calibration optical signal entering into the right end 3111a. Here, "substantially the same as" may mean that intensities of the two optical signals is completely the same, or a difference between intensities of the two optical signals is small and negligible.

The receiving unit 3043 is aligned with at least a part of area of a left end 3111b of the first calibration optical path 3111, and a part of the calibration optical signal transmitted through the first calibration optical path 3111 is received by the receiving unit 3043, that is, intensity of the calibration optical signal transmitted by the transmission unit 3042 is greater than that of the calibration optical signal received by the receiving unit 3043, and an offset of the first calibration optical path 3111 with respect to the horizontal plane may be calculated according to a difference between intensities of the two optical signals.

It is to be noted that a plane where the transmission unit 3042 and the receiving unit 3043 are located is arranged to be parallel to the horizontal plane, when the picking surface 301b is inclined with respect to the horizontal plane, and the calibration plane parallel to the picking surface 301b is also inclined with respect to the horizontal plane, that is, the first calibration optical path 3111 is also inclined with respect to the horizontal plane. Therefore, when the right end 3111a of the transmission unit 3042 is completely aligned, the receiving unit 3043 is aligned with a part of area of the left end 3111b. "aligned with a part of area" does not include complete alignment. It may be understood that when the receiving unit 3043 is aligned with a part of area of the left end 3111b, only a part of the calibration optical signal may be received by the receiving unit 3043, and intensity of the calibration optical signal received by the receiving unit 3043 is less than that of the calibration optical signal transmitted by the transmission unit 3042.

When the picking surface 301b is parallel to the horizontal plane, and the calibration plane parallel to the picking surface 301b is also parallel to the horizontal plane, that is, the first calibration optical path 3111 is also parallel to the horizontal plane. Therefore, when the right end 3111a of the transmission unit 3042 is completely aligned, the receiving unit 3043 is also completely aligned with the left end 3111b, and intensity of the calibration optical signal received by the receiving unit 3043 is substantially the same as that of the calibration optical signal transmitted by the transmission unit 3042.

The calibration optical signal transmitted by the transmission unit 3042 is transmitted to the receiving unit 3043 through the first calibration optical path 3111. The receiving unit 3043 may determine the first sub-offset according to intensity I₁ of the transmitted calibration optical signal and intensity I₁' of a received calibration optical signal.

Exemplarily, with reference to FIG. 4A and FIG. 4B, the driving unit may take an axis penetrating center of the calibration plane as a centerline, to drive the bonding head 301 to rotate until a left end 3112b of the second calibration optical path 3112 is aligned with the transmission unit 3042, and the receiving unit 3043 is aligned with at least a part of area of a right end 3112a of the second calibration optical path 3112.

Similarly, when the picking surface 301b is inclined with respect to the horizontal plane, the second calibration optical path 3112 is also inclined with respect to the horizontal plane. Therefore, when the left end 3112b is completely aligned with the transmission unit 3042, the receiving unit 3043 is only aligned with a part of area of the right end 3112a.

When the picking surface 301b is parallel to the horizontal plane, the second calibration optical path 3112 is also parallel to the horizontal plane. Therefore, when the left end 3112b is completely aligned with the transmission unit 3042, the receiving unit 3043 is also completely aligned with the right end 3112a.

The calibration optical signal transmitted by the transmission unit 3042 is transmitted to the receiving unit 3043 through the second calibration optical path 3112. The receiving unit 3043 may determine the second sub-offset according to intensity I₂ of the transmitted calibration optical signal and intensity I₂' of a received calibration optical signal. The first alignment assembly 304 may determine the offset of the picking surface 301b with respect to the horizontal plane according to the first sub-offset and the second sub-offset.

It may be understood that in the embodiments of the present disclosure, a transmission unit and a receiving unit are arranged, the first sub-offset may be determined through the first calibration optical path, and then the second sub-offset may be determined through the second calibration optical path. An offset of a calibration plane where the two calibration optical paths are arranged with respect to the horizontal plane may be determined according to the first sub-offset and the second sub-offset, and thus the offset of the picking surface parallel to the calibration plane with respect to the horizontal plane is determined.

In some embodiments, the first alignment assembly 304 may include two transmission units 3042 and two receiving units 3043.

When the bonding head 301 is located at the first position, a first transmission unit 3042 is aligned with an end of a first calibration optical path, and a first receiving unit 3043 is aligned with at least a part of area of another end of the first calibration optical path; a second transmission unit 3042 is aligned with an end of a second calibration optical path, and a second receiving unit 3043 is aligned with at least a part of area of another end of the second calibration optical path.

The first transmission unit 3042 is configured to transmit a calibration optical signal to the end of the first calibration optical path.

The first receiving unit 3043 is configured to determine a first sub-offset according to a received calibration optical signal transmitted through the first calibration optical path.

The second transmission unit 3042 is configured to transmit a calibration optical signal to the end of the second calibration optical path.

The second receiving unit 3043 is configured to determine a second sub-offset according to a received calibration optical signal transmitted through the second calibration optical path.

The first alignment assembly 304 is specifically configured to determine the offset according to the first sub-offset and the second sub-offset.

FIG. 4B shows two transmission units 3042 arranged in parallel along the y direction and two receiving units 3043 arranged in parallel along the y direction. The first transmission unit 3042 and the first receiving unit 3043 are arranged in parallel along the x direction and are located at two sides of the first calibration optical path 3111 which are arranged opposite to each other in the x direction respectively. For example, the first transmission unit 3042 is located at a right or left side of the first calibration optical path 3111, and the first receiving unit 3043 is located at a left or right side of the first calibration optical path 3111.

The second transmission unit 3042 and the second receiving unit 3043 are arranged in parallel along the x direction and are located at two sides of the second calibration optical path 3112 which are arranged opposite to each other in the x direction respectively. For example, the second transmission unit 3042 is located at a right or left side of the second calibration optical path 3112, and the second receiving unit 3043 is located at a left or right side of the second calibration optical path 3112.

Two calibration optical paths arranged in parallel along the y direction and a pair of transmission unit and receiving unit located at two sides of a calibration optical path which are arranged opposite to each other in the x direction respectively, are shown in this example. However, in other example, two calibration optical paths may also be arranged in parallel along the x direction, and a pair of transmission unit and receiving unit are located at two sides of a calibration optical path which are arranged opposite to each other in the y direction respectively; two calibration optical paths may also be arranged in other manners, which are not limited here by the present disclosure.

The calibration optical signal transmitted by the first transmission unit 3042 is transmitted to the first receiving unit 3043 through the first calibration optical path 3111. The first receiving unit 3043 may determine the first sub-offset according to intensity I₁ of the transmitted calibration optical signal and intensity I₁' of a received calibration optical signal.

The calibration optical signal transmitted by the second transmission unit 3042 is transmitted to the second receiving unit 3043 through the second calibration optical path 3112. The second receiving unit 3043 may determine the second sub-offset according to intensity I₂ of the transmitted calibration optical signal and intensity I₂' of a received calibration optical signal. The first alignment assembly 304 may determine the offset of the picking surface 301b with respect to the horizontal plane according to the first sub-offset and the second sub-offset.

It may be understood that in the embodiments of the present disclosure, two transmission units and two receiving units are arranged, a pair of transmission unit and receiving unit may determine the first sub-offset of the first calibration optical path, and another pair of transmission unit and receiving unit may determine the second sub-offset of the second calibration optical path, without driving the bonding head to rotate, which is conducive to improving accuracy of the first sub-offset and the second sub-offset.

Furthermore, in the embodiments of the present disclosure, two pairs of transmission units and receiving units may determine the first sub-offset of the first calibration optical path and the second sub-offset of the second calibration optical path simultaneously, which may shorten the time for determining the offset, and thus shorten the time for levelness detection and horizontal adjustment before die to wafer bonding, improving bonding efficiency.

In some embodiments, with reference to FIG. 3A and FIG. 3C, the second end 302b of the first optical path 302 is arranged on the side surface 301c.

The first optical path 302 includes a first reflector 3021 configured to reflect an optical signal transmitted between the first end 302a of the first optical path 302 and the second end 302b of the first optical path 302.

The first alignment assembly 304 includes a second optical path 306 and an aligner 3041, here the aligner 3041 is configured to transmit a detection optical signal, receive a reflection optical signal, and determine a first deviation value.

Here, when the bonding head 301 is located at the second position, the aligner 3041 is located at an end of the second optical path 306 away from the side surface 301c, and another end of the second optical path 306 relatively close to the side surface 301c is aligned with the second end 302b of the first optical path 302.

Exemplarily, with reference to FIG. 3A, when the bonding head 301 is located at the second position, the aligner 3041 transmits a detection optical signal which is transmitted to a positioning mark (shown by "+" in FIG. 3C) of the first to-be-bonded die **11** through the second optical path 306 and the first optical path 302 and forms a reflection optical signal, the reflection optical signal is transmitted to the aligner 3041 through the first optical path 302 and the second optical path 306.

Exemplarily, with reference to FIG. 3C, the first reflector 3021 is located between the first end 302a of the first optical path 302 and the second end 302b of the first optical path 302, and is configured to reflect the detection optical signal received by the second end 302b of the first optical path 302 to the first end 302a of the first optical path 302, so as to be transmitted to the positioning mark of the first to-be-bonded die 11, and is further configured to reflect the detection optical signal received by the first end 302a of the first optical path 302 to the second end 302b of the first optical path 302, so as to be transmitted to the aligner 3041.

The aligner 3041 includes a device integrated with an optical transmitter and an optical detector. The optical transmitter is configured to transmit the detection optical signal, and the optical detector is configured to receive the reflection optical signal. Furthermore, the aligner 3041 may also include an image sensor connected to the optical detector and configured to convert the received reflection optical signal into a visual image, the first deviation value may be determined according to the image.

In the embodiments of the present disclosure, the second optical path and the aligner are arranged, the second optical path is aligned with the first optical path and is located between the aligner and the first optical path, which is conducive to transmission of the detection optical signal or reflection optical signal between the aligner and the first to-be-bonded die, may locate the current position of the first to-be-bonded die accurately, and is conducive to improving accuracy of the first deviation value.

Furthermore, the first alignment assembly and the bonding assembly are arranged separately, that is, the first alignment assembly is arranged outside the bonding assembly, which does not increase weight of the bonding head additionally and allows inertia of the bonding assembly to be small. Furthermore, since the first alignment assembly is arranged outside the bonding assembly, the first alignment assembly does not affect movement of the bonding assembly, which may ensure that the bonding assembly moves with high frequency and high accuracy in the vertical direction, improving bonding accuracy while improving bonding efficiency.

In some embodiments, with reference to FIG. 3A and FIG. 3C, when the bonding head 301 is located at the second position, the second optical path 306 is parallel to the picking surface 301b. It may be understood that in the embodiments of the present disclosure, the second optical path may be arranged along the horizontal direction, and the detection optical signal and the reflection optical signal may be transmitted in the second optical path along the horizontal direction.

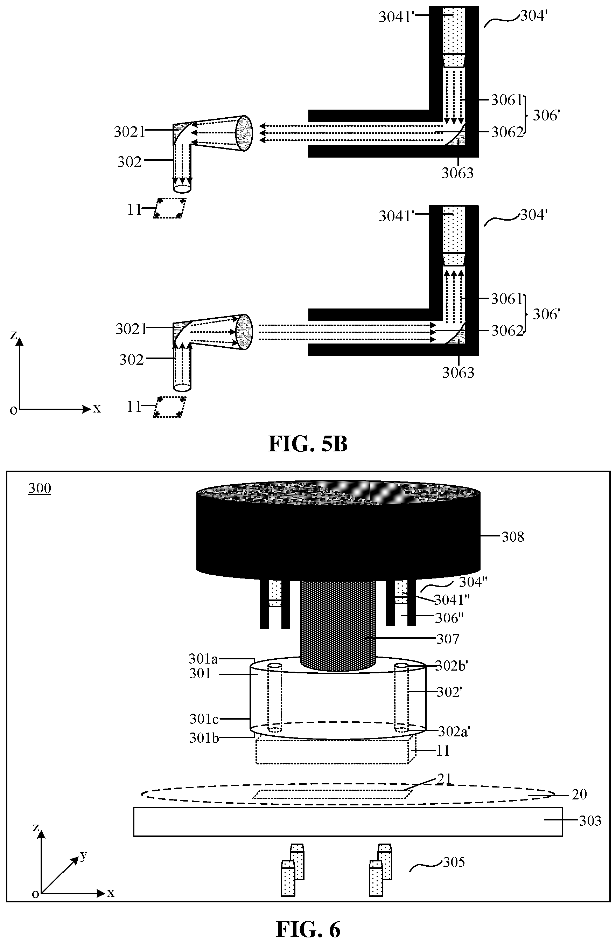

In some embodiments, with reference to FIG. 5A and FIG. 5B, the second optical path 306' includes a first sub-path 3061, a second sub-path 3062, and a second reflector 3063. The first sub-path 3061 is perpendicular to the second sub-path 3062, the second reflector 3063 is located at intersection of the first sub-path 3061 and the second sub-path 3062 and is configured to reflect an optical signal transmitted between the first sub-path 3061 and the second sub-path 3062.

An aligner 3041' is located at an end of the first sub-path 3061 away from the second sub-path 3062.

Here, when the bonding head 301 is located at the second position, the first sub-path 3061 is perpendicular to the picking surface 301b, the second sub-path 3062 is parallel to the picking surface 301b, and an end of the second sub-path 3062 relatively close to the side surface 301c is aligned with the second end 302b of the first optical path 302.

Exemplarily, with reference to FIG. 5B, when the bonding head 301 is located at the second position, the aligner 3041' transmits a detection optical signal which is transmitted to a positioning mark (shown by "+" in FIG. 5B) of the first to-be-bonded die **11** through the first sub-path 3061, the second sub-path 3062 and the first optical path 302 and forms a reflection optical signal, the reflection optical signal is transmitted to the aligner 3041' through the first optical path 302, the second sub-path 3062 and the first sub-path 3061.

Exemplarily, with reference to FIG. 5B, the second reflector 3063 is located between the first sub-path 3061 and the second sub-path 3062, and is configured to reflect the detection optical signal received by the first sub-path 3061 to the second sub-path 3062, so as to be transmitted to the first optical path 302, and is further configured to reflect a reflection optical signal received by the second sub-path 3062 to the first sub-path 3061, so as to be transmitted to the aligner 3041'.

Here, the aligner 3041' is the same as the aligner 3041 in the above embodiments, and is not repeated here in the present disclosure.

It may be understood that in the embodiments of the present disclosure, the second optical path may be configured as "L" shape, and include the first sub-path in the vertical direction and the second sub-path in the horizontal direction. When the second end of the first optical path is located on the side surface of the bonding head, the second sub-path is aligned with the second end of the first optical path to ensure transmission of the detection optical signal and reflection optical signal in the first optical path and the second optical path, and to locate the current position of the first to-be-bonded die accurately.

Furthermore, diversity of manners of configuring optical paths in the first alignment assembly is increased by configuring the second optical path as "L" shape. In a practical application, optical paths in the first alignment assembly may be configured reasonably by those skilled in the art according to actual requirements of the bonding process, which are not limited here by the present disclosure.

Preferably, the second optical path is arranged in the horizontal direction (as shown in FIG. 3A and FIG. 3B). Compared with the second optical path configured as "L" type (as shown in FIG. 4A and

FIG. 4B), the second optical path is arranged in the horizontal direction, which may simplify design of the optical path, reduce transmission loss of the detection optical signal or reflection optical signal in the second optical path, improve accuracy of locating the first to-be-bonded die, and thus improve accuracy of the first deviation value.

In some embodiments, with reference to FIG. 6, the top surface 301a includes a first area and a second area.

The bonding assembly also includes a fixation unit 307 and a mobile unit 308. The fixation unit 307 fixedly connects the first area to the mobile unit 308. The mobile unit 308 is configured to move the bonding head 301 relative to the wafer stage 303.

A first optical path 302' passes through the bonding head 301 in a direction perpendicular to the picking surface 301b, here a second end 302b' of the first optical path 302' is located in the second area.

A first alignment assembly 304" with a projection in the horizontal direction located in the second area, includes a second optical path 306" and an aligner 3041", here the aligner 3041" is configured to transmit a detection optical signal, receive a reflection optical signal, and determine a first deviation value.

Here, the second optical path 306" is perpendicular to the picking surface 301b and is aligned with the first optical path 302'. The aligner 3041" is located at an end of the second optical path 306" away from the bonding head 301.

Exemplarily, with reference to FIG. 6, the bonding head 301 includes a picking surface 301b and a top surface 301a arranged opposite to each other in the z direction. The fixation unit 307 is located between the bonding head 301 and the mobile unit 308. An end of the fixation unit 307 is fixedly connected to the top surface 301a of the bonding head 301, and another end of the fixation unit 307 is fixedly connected to the mobile unit 308.

Here, the first area represents an area where the top surface 301a of the bonding head 301 contacts the fixation unit 307, and the second area represents an area where the top surface 301a of the bonding head 301 does not contact the fixation unit 307. It may be understood that a projection of the fixation unit 307 in the horizontal direction is located in the first area.

Exemplarily, with reference to FIG. 6, the first optical path 302' passes through the bonding head 301, and includes a first end 302a' and a second end 302b'. It may be understood that a horizontal plane where the first end 302a' is located is flush with a horizontal plane where the picking surface 301b is located, and a horizontal plane where the second end 302b' is located is flush with a horizontal plane where the top surface 301a is located, and is located in the second area.

Exemplarily, with reference to FIG. 6, the first alignment assembly 304" is located above the first optical path 302', and the second optical path 306" is arranged parallel to the z-axis direction and is aligned with the first optical path 302'. In this example, the first alignment assembly 304" may be fixedly connected to the mobile unit 308.

In some embodiments, the first alignment assembly 304" may be arranged on the top surface 301a of the bonding head 301, as long as it ensures that the second optical path is aligned with the first optical path.

In some embodiments, the first alignment assembly 304" may be fixed through an external bracket, without being fixedly connected to the mobile unit 308, as long as it ensures that the second optical path is aligned with the first optical path. At this time, the fixation unit 307 configured to connect the mobile unit 308 to the bonding head 301 may be a retractable device to avoid the first alignment assembly 304" and the external bracket from blocking up and down movement of the bonding assembly.

It may be understood that a manner of fixing the first alignment assembly 304" through the external bracket does not increase weight of the bonding assembly additionally and allows inertia of the bonding assembly to be small, which may ensure that the bonding assembly moves with high frequency and high accuracy in the vertical direction, improving bonding accuracy while improving bonding efficiency.

Compared with the second end of the first optical path arranged on the side surface of the bonding head, it is configured in the embodiments of the present disclosure that the first optical path passes through the bonding head, the second end of the first optical path is located on the top surface of the bonding head. In this way, the detection optical signal or reflection optical signal may be transmitted in the first optical path along the vertical direction, without arranging the first reflector in the first optical path, which simplifies structure of the bonding assembly and is conducive to reducing difficulty of manufacturing the bonding assembly while reducing cost of manufacturing the bonding assembly.

Furthermore, since it is not required to add the first reflector in the first optical path additionally, loss caused by reflection of the detection optical signal or reflection optical signal at the position of the first reflector is reduced, which is conducive to locating the current position of the first to-be-bonded die accurately, and thus improving accuracy of the first deviation value.

In some embodiments, the bonding assembly includes two first optical paths, first ends of different first optical paths are arranged in different positions, and second ends of different first optical paths are arranged in different positions on the picking surface.

The first alignment assembly includes an aligner, here when the bonding head is located at the second position, the aligner is aligned with the second end of a first optical path.

The bonding assembly also includes a driving unit configured to driving the two first optical paths to move relative to the aligner, so that the aligner is aligned with the second end of another first optical path.

Exemplarily, when the to-be-bonded die 11 includes two sets of positioning marks arranged in parallel along the x direction, each set of positioning marks includes a positioning mark, or at least two positioning marks arranged in parallel along the y direction. With reference to FIG. 3A, the bonding assembly may include two first optical paths 302 arranged in parallel along the x direction. When the bonding head 301 is located at the second position, first ends 302a of the two first optical paths 302 expose two sets of positioning marks in the first to-be-bonded die 11 respectively.

Exemplarily, with reference to FIG. 3A and FIG. 3C, the first alignment assembly may include an aligner 3041 located at a side of the bonding head 301. When the bonding head 301 is located at the second position, the aligner 3041 is aligned with a 1^{st} first optical path 302 to locate, through the 1^{st} first optical path 302, a position of a first set of positioning marks exposed by the 1^{st} first optical path 302.

Exemplarily, the driving unit may be connected with the mobile unit 308 to drive the mobile unit 308 to rotate clockwise or counter-clockwise relative to the aligner 3041. When the mobile unit 308 rotates, the fixation unit 307, the bonding head 301 and the first to-be-bonded die 11 rotate synchronously. In this way, a 2^{nd} first optical path 302 may be rotated to a position aligned with the aligner 3041, so that the aligner 3041 is aligned with the 2^{nd} first optical path 302 to locate, through the 2^{nd} first optical path 302, a position of a second set of positioning marks exposed by the 2^{nd} first optical path 302.

For example, the two first optical paths 302 are arranged in parallel along the x direction, and second ends 302b of the two first optical paths 302 are located in the same horizontal plane. After the aligner 3041 is aligned with the 1^{st} first optical path 302, the driving unit may drive the mobile unit 308 to clockwise or counter-clockwise rotate by 180° relative to the aligner 3041, so that the 2^{nd} first optical path 302 is aligned with the aligner 3041. At this time, the 1^{st} first optical path 302 rotates to an original position of the 2^{nd} first optical path 302.

It is to be noted that during rotation of the mobile unit, the first to-be-bonded die 11 also rotates synchronously, therefore a current position of the first set of positioning marks may change after rotation. It is to be understood that a coordinate system established to locate the first target position and the current position of the first set of positioning marks may also change after rotation.

For example, based on a coordinate system established before rotation, the current position of the first set of positioning marks is located as (x₃, y₃), and based on a coordinate system established after clockwise or counter-clockwise rotating by 180°, the current position of the first set of positioning marks is located as (-x₃, -y₃), and the first target position is located as (-x₀, -y₀).

In a practical application, the bonding head may have a cylindrical shape, and the picking surface may have a circular shape. The position of the first set of positioning marks after rotation and the first target position after rotation may be determined according to angle and direction of rotation of the mobile unit 308 and a radius of the picking surface.

Exemplarily, based on the coordinate system established after clockwise or counter-clockwise rotating by 180°, the current position of the first set of positioning marks is marked as (-x₃, -y₃), and a current position of the second set of positioning marks is marked as (x₄, y₄). The current position (x₁', y₁') of the first to-be-bonded die 11 is determined according to the current position of the first set of positioning marks and the current position of the second set of positioning marks, here x₁' = (x₄ - x₃) / 2, y₁' = (y₄ - y₃) / 2. The first deviation value is marked as (Δx_{T}', Δy_{T}'), here Δx_{T}' = x₁' - (-x₀), Δy_{T}' = y₁' - (-y₀).

It may be understood that an angle of the mobile unit rotating relative to the aligner may be determined based on positions where the 1^{st} first optical path and the 2^{nd} first optical path are arranged. Here, the two first optical paths arranged in parallel along the x direction are merely illustrative, to convey the present disclosure to those skilled in the art. However, the present disclosure is not limited thereto. In other examples, the two first optical paths may also be arranged in other manners, for example, according to a manner of arranging multiple sets of positioning marks in the first to-be-bonded die.

In the embodiments of the present disclosure, an aligner is provided, to implement alignment of an aligner with two first optical paths respectively, and then positioning marks on the first to-be-bonded die is located through the first optical path aligned with the aligner.

In some embodiments, the bonding assembly includes two first optical paths, first ends of different first optical paths are arranged in different positions, and second ends of different first optical paths are arranged in different positions on the picking surface.

The first alignment assembly includes two aligners and two second optical paths, here different aligners are located at ends of different second optical paths away from the bonding head.

Here, when the bonding head is located at the second position, different second optical paths are aligned with different first optical paths.

Exemplarily, with reference to FIG. 3A, the bonding assembly may include two first optical paths 302 arranged in parallel along the x direction. The first alignment assembly 304 includes two aligners 3041 and two second optical paths 306 arranged in parallel along the x direction. Each aligner 3041 is aligned with one of the first optical paths 302 through one of the second optical paths 306.

It is to be noted that the bonding assembly including two first optical paths, and the first alignment assembly including two aligners and two second optical paths are shown in this example. In other examples, the bonding assembly may include at least three first optical paths, and the first alignment assembly may include at least three aligners and three second optical paths.

For example, based on what shown in FIG. 3A, the bonding assembly also includes two first optical paths arranged in parallel along the y direction, the first alignment assembly also includes two aligners arranged in parallel along the y direction and two second optical paths arranged in parallel along the y direction. In this way, the bonding assembly is provided with four first optical paths, the first alignment assembly is provided with four aligners and four second optical paths. Each aligner is aligned with one of the first optical paths through one of the second optical paths.

Here, the number or positions of arranging the first optical paths in the bonding assembly and the number or positions of arranging the aligners in the first bonding assembly may be set according to the number or positions of the calibration marks in the first to-be-bonded die, and are not further limited by the present disclosure.

Compared with an aligner configured to align with at least two first optical paths, two aligners are arranged in the embodiments of the present disclosure, so that an aligner may align with a first optical path through a second optical path. Each aligner may locate each positioning mark independently, which is conducive to improving accuracy of locating the positioning mark.

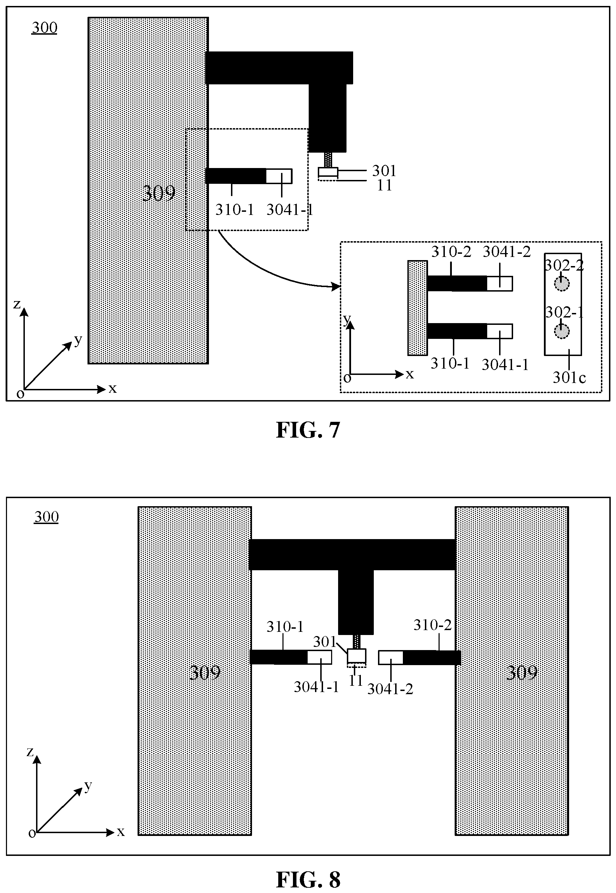

In some embodiments, with reference to FIG. 3A and FIG. 7, the bonding system 300 further includes a base 309, a first bracket 310-1 and a second bracket 310-2.

The base 309 is located on the side surface 301c of the bonding head 301.

The first bracket 310-1 is arranged parallel to the picking surface 301b and is configured to fixedly connect a first aligner 3041-1 to the base 309.

The second bracket 310-2 is arranged parallel to the picking surface 301b and is configured to fixedly connect a second aligner 3041-2 to the base 309.

FIG. 7 shows a top view of a part of the bonding system 300 in the xoy plane. The bonding assembly may include the 1^{st} first optical path 302-1 and the 2^{nd} first optical path 302-2 arranged in parallel along the y direction. The first alignment assembly may include the first aligner 3041-1 and the second aligner 3041-2 arranged in parallel along the y direction. When the bonding head 301 is located at the second position, the first aligner 3041-1 is aligned with the 1^{st} first optical path 302-1, and the second aligner 3041-2 is aligned with the 2^{nd} first optical path 302-2.

The first aligner 3041-1 is fixedly connected to the base 309 through the first bracket 310-1, and the second aligner 3041-2 is fixedly connected to the base 309 through the second bracket 310-2. It may be understood that projections of the first aligner 3041-1 and the second aligner 3041-2 in the xoz plane coincide, that is, the first aligner 3041-1 and the second aligner 3041-2 are located at the same side of the bonding head 301.

In some embodiments, with reference to FIG. 3A and FIG. 8, the bonding system 300 further includes two bases 309, a first bracket 310-1 and a second bracket 310-2.

The two bases 309 are arranged at two sides of the bonding head 301 respectively.

The first bracket 310-1 is arranged parallel to the picking surface 301b and is configured to fixedly connect the first aligner 3041-1 to the first base 309.

The second bracket 310-2 is arranged parallel to the picking surface 301b and is configured to fixedly connect the second aligner 3041-2 to the second base 309.

FIG. 8 shows a schematic structural view of a part of the bonding system 300. The bonding assembly may include two first optical paths arranged in parallel along the x direction. The first alignment assembly may include the first aligner 3041-1 and the second aligner 3041-2 arranged in parallel along the x direction. When the bonding head 301 is located at the second position, the first aligner 3041-1 is aligned with the first optical path at the left side of the bonding head 301, and the second aligner 3041-2 is aligned with the first optical path at the right side of the bonding head 301.

The first aligner 3041-1 is fixedly connected to the base 309 at the left side of the bonding head through the first bracket 310-1, and the second aligner 3041-2 is fixedly connected to the base 309 at the right side of the bonding head through the second bracket 310-2. The first aligner 3041-1 and the second aligner 3041-2 are located at two sides of the bonding head 301.

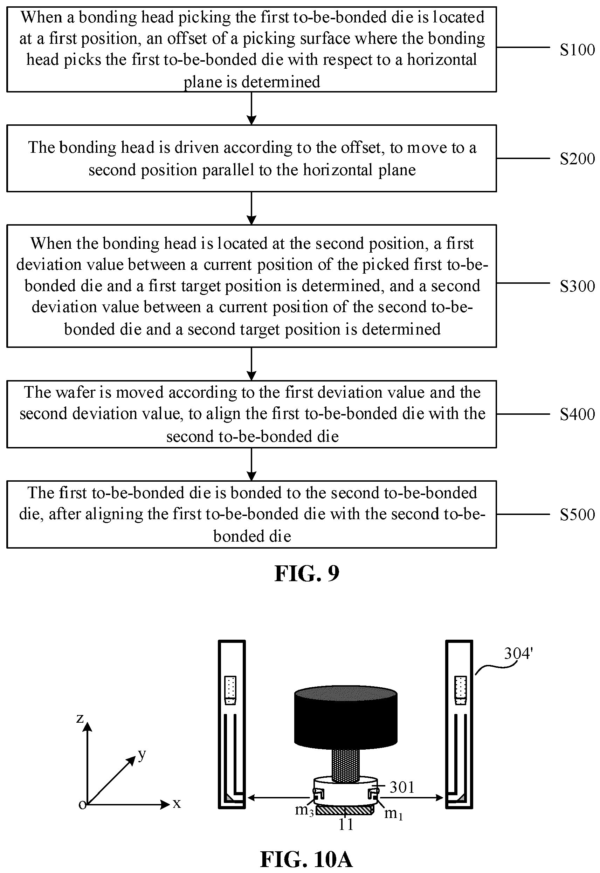

FIG. 9 shows a schematic flowchart of a bonding method according to an embodiment of the present disclosure. FIG. 10A to FIG. 10D show schematic process views of a bonding method according to an embodiment of the present disclosure. The bonding method is applied to bonding a first to-be-bonded die 11 to a second to-be-bonded die 21 on a wafer, and includes the following operations S100 to S500.

In operation S100, when a bonding head picking the first to-be-bonded die is located at a first position, an offset of a picking surface where the bonding head picks the first to-be-bonded die with respect to a horizontal plane is determined.

In operation S200, the bonding head is driven according to the offset, to move to a second position parallel to the horizontal plane.

In operation S300, when the bonding head is located at the second position, a first deviation value between a current position of the picked first to-be-bonded die and a first target position is determined, and a second deviation value between a current position of the second to-be-bonded die and a second target position is determined.

In operation S400, the wafer or the first to-be-bonded die is moved according to the first deviation value and the second deviation value, to align the first to-be-bonded die with the second to-be-bonded die.

In operation S500, the first to-be-bonded die is bonded to the second to-be-bonded die, after aligning the first to-be-bonded die with the second to-be-bonded die.

In operation S100, with reference to FIG. 10A, when the bonding head 301 picking the first to-be-bonded die **11** is located at the first position, the offset of the picking surface with respect to the horizontal plane (e.g., an xoy plane) may be detected by using the first alignment assembly 304', and the offset may be expressed by an angle between the picking surface and the horizontal plane, or by heights of multiple points on the picking surface with respect to the same horizontal plane.

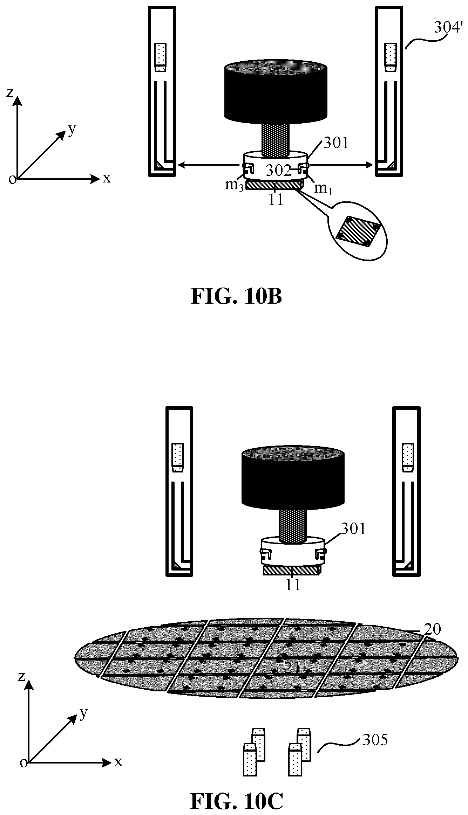

In operation S200, with reference to FIG. 10B, after determining the offset of the picking surface with respect to the horizontal plane, the bonding assembly may drive the bonding head 301 to rotate until the picking surface is parallel to the horizontal plane, and adjust the bonding head 301 to the second position. Here, the second position represents a position where the first optical path 302 may receive the detection optical signal transmitted by the first alignment assembly 304'.

In operation S300, with reference to FIG. 10B, the first deviation value (Δx₁, Δy_{T}) between the current position (x₁, y₁) of the first to-be-bonded die 11 and the first target position (x₀, y₀) may be determined by using the first alignment assembly 304', here Δx_{T} = x₁ - x₀, Δy_{T} = y₁ - y₀.

In operation S300, with reference to FIG. 10C, after determining the first deviation value, the wafer 20 is transmitted to the stage, the second deviation value (Δx_{B}, Δy_{B}) between the current position (x₂, y₂) of the second to-be-bonded die 21 on the wafer 20 and the second target position (x₀', y₀') may be determined by using the second alignment assembly 305, here Δx_{B} = x₂ - x₀', Δy_{T} = y₂ - y₀'.

It is to be noted that the first target position and the second target position have the same position in the horizontal direction, while have different positions in the vertical direction, that is, x₀ is the same as x₀', y₀ is the same as y₀', and the first target position and the second target position have different coordinates in the z direction. Different reference numerals are only intended to facilitate distinction between the first target position and the second target position, and are not intended to limit the present disclosure.

In operation S400, a displacement deviation between the first to-be-bonded die 11 and the second to-be-bonded die 21 is determined to be (Δx_{T} - Δx_{B}, Δy_{T} - Δy_{B}) according to the first deviation value and the second deviation value. The bonding assembly may be kept fixed (that is, the first to-be-bonded die 11 is kept fixed), and the wafer 20 moves by (Δx_{T} - Δx_{B}, Δy_{T} - Δy_{B}) horizontally according to the displacement deviation, so that the second to-be-bonded die 21 is aligned with the first to-be-bonded die 11, that is, positions of the first to-be-bonded die 11 and the second to-be-bonded die 21 in the horizontal direction are the same.

Here, a direction in which the wafer 20 moves may be determined according to a positive or negative value of Δx_{T} - Δx_{B}. For example, when Δx_{T} - Δx_{B} is a negative value, the wafer 20 moves in a negative direction of x-axis, and a movement distance is an absolute value of (Δx_{T} - Δx_{B}). When Δx_{T} - Δx_{B} is a positive value, the wafer 20 moves in a positive direction of x-axis, and a movement distance is (Δx_{T} - Δx_{B}).

Similarly, a direction in which the wafer 20 moves may be determined according to a positive or negative value of Δy_{T} - Δy_{B}. For example, when Δy_{T} - Δy_{B} is a negative value, the wafer 20 moves in a negative direction of y-axis, and a movement distance is an absolute value of (Δy_{T} - Δy_{B}). When Δy_{T} - Δy_{B} is a positive value, the wafer 20 moves in a positive direction of y-axis, and a movement distance is (Δy_{T} - Δy_{B}).

In operation S400, a displacement deviation between the first to-be-bonded die 11 and the second to-be-bonded die 21 is determined to be (Δx_{T} - Δx_{B}, Δy_{T} - Δy_{B}) according to the first deviation value and the second deviation value. The wafer 20 may also be kept fixed (that is, the second to-be-bonded die 21 is kept fixed), and the first to-be-bonded die 11 moves by (Δx_{T} - Δx_{B}, Δy_{T} - Δy_{B}) horizontally according to the displacement deviation, so that the first to-be-bonded die 11 is aligned with the second to-be-bonded die 21.

Here, a direction in which the first to-be-bonded die 11 moves may be determined according to a positive or negative value of Δx_{T} - Δx_{B}. For example, when Δx_{T} - Δx_{B} is a negative value, the first to-be-bonded die 11 moves in a positive direction of x-axis, and a movement distance is an absolute value of (Δx_{T} - Δx_{B}). When Δx_{T} - Δx_{B} is a positive value, the first to-be-bonded die 11 moves in a negative direction of x-axis, and a movement distance is (Δx_{T} - Δx_{B}).

Similarly, a direction in which the first to-be-bonded die 11 moves may be determined according to a positive or negative value of Δy_{T} - Δy_{B}. For example, when Δy_{T} - Δy_{B} is a negative value, the first to-be-bonded die 11 moves in a positive direction of y-axis, and a movement distance is an absolute value of (Δy_{T} - Δy_{B}). When Δy_{T} - Δy_{B} is a positive value, the first to-be-bonded die 11 moves in a negative direction of y-axis, and a movement distance is (Δy_{T} - Δy_{B}).

In operation S400, after determining the first deviation value and the second deviation value, the wafer or the first to-be-bonded die 11 may be moved to align the first to-be-bonded die with the second to-be-bonded die. Preferably, the wafer is moved to align the second to-be-bonded die with the first to-be-bonded die.

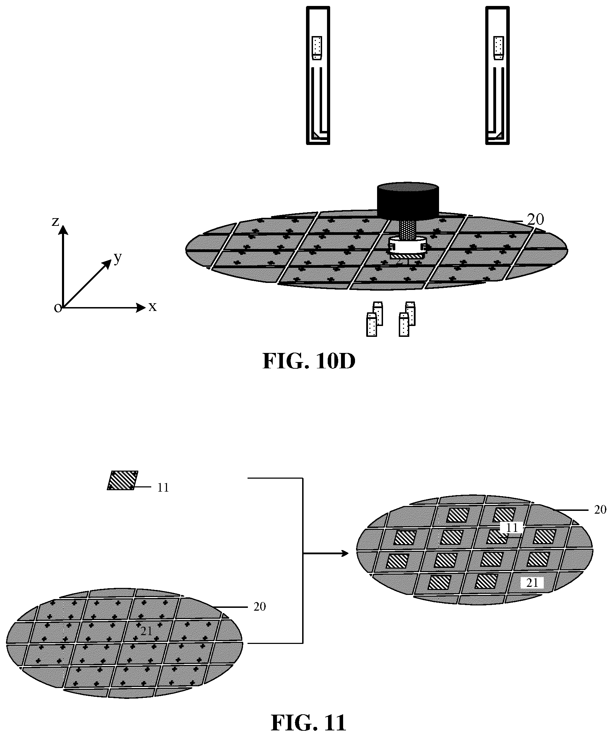

In operation S500, with reference to FIG. 10D, after aligning the first to-be-bonded die 11 with the second to-be-bonded die 21, the bonding assembly vertically moves downward, to bond the first to-be-bonded die 11 to the second to-be-bonded die 21.

It is to be noted that the first to-be-bonded die **11** is a die independent of the wafer. In the process of manufacturing semiconductor devices, multiple dies are usually formed on the wafer. Here, the first to-be-bonded die **11** refers to an independent die formed after the wafer carrying multiple dies is cut. It may be understood that the first to-be-bonded die has a size much less than that of the wafer.

In the embodiments of the present disclosure, when the bonding head is located at the first position, the offset of the picking surface of the bonding head with respect to the horizontal plane is determined, and the bonding head may be driven according to the offset, to move to the second position parallel to the horizontal plane. That is, the picked die may be adjusted to be parallel to the horizontal plane before die to wafer bonding, which is conducive to reducing a probability of breakage of the die due to uneven local stress upon bonding and improving yield rate of die to wafer bonding.

After adjusting the die to the second position parallel to the horizontal plane, the first deviation value between the current position of the first to-be-bonded die and the first target position is determined, the second deviation value between the current position of the second to-be-bonded die on the wafer and the second target position is determined, and the wafer or the first to-be-bonded die is adjusted according to the first deviation value and the second deviation value, which may align the first to-be-bonded die with the second to-be-bonded die accurately, and is conducive to improving accuracy of die to wafer bonding.

In some embodiments, the bonding head may include a side surface perpendicular to the picking surface, a top surface parallel to the picking surface, and at least three calibration marks, here the at least three calibration marks are located on the side surface or the top surface, and a plane where the at least three calibration marks are located is parallel to the picking surface.

Determining the offset of the picking surface of the bonding head with respect to the horizontal plane may include the following operations.

A first image including a first one of the calibration marks is acquired.

A first sub-deviation between a position of the first one of the calibration marks and the preset position is determined according to the first image.

The bonding head is driven to rotate by a first angle after acquiring the first image.

A second image including a second one of the calibration marks is acquired after the bonding head rotates by the first angle.

A second sub-deviation between a position of the second one of the calibration marks and the preset position is determined according to the second image.

The bonding head is driven to rotate by a second angle after acquiring the second image.

A third image including a third one of the calibration marks is acquired after the bonding head rotates by the second angle.

A third sub-deviation between a position of the third one of the calibration marks and the preset position is determined according to the third image.

The offset is determined according to the first sub-deviation, the second sub-deviation and the third sub-deviation.

Exemplarily, with reference to FIG. 5A and FIG. 10A, calibration marks m₁, m₂ and m₃ are located on the side surface 301c, a plane composed of the calibration marks m₁, m₂ and m₃ is marked as a calibration plane which is parallel to the picking surface 301b.

When the bonding head 301 is located at the first position, the first alignment assembly 304' acquires the first image including the first calibration mark m₁, and determines the first sub-deviation (Δyₘ₁) between the position (xₘ₁, yₘ₁) of the first calibration mark m₁ and the preset position (x_{c}, y_{c}) according to the first image, Δyₘ₁ = yₘ₁ - y_{c}.

The driving unit drives the mobile unit 308 to clockwise rotate by a first angle. When the mobile unit 308 rotates, the fixation unit 307, the bonding head 301 and the first to-be-bonded die 11 rotate synchronously, the first alignment assembly 304' acquires the second image including the second calibration mark m₂, and determines the second sub-deviation (Δyₘ₂) between the position (xₘ₂, yₘ₂) of the second calibration mark m₂ and the preset position (x_{c}, y_{c}) according to the second image, Δyₘ₂ = yₘ₂ - y_{c}.

Then the driving unit drives the mobile unit 308 to clockwise rotate by a second angle, the first alignment assembly 304' acquires the third image including the third calibration mark m₃, and determines the third sub-deviation (Δyₘ₃) between the position (xₘ₃, yₘ₃) of the third calibration mark m₃ and the preset position (x_{c}, y_{c}) according to the third image, Δyₘ₃ = yₘ₃ - y_{c}. The offset of the picking surface with respect to the horizontal plane is determined according to Δyₘ₁, Δyₘ₂ and Δyₘ₃.

Here, the preset position represents a central position of a finder frame by which the first alignment assembly 304' determines positions of the calibration marks m₁, m₂ and m₃, and is marked as (x_{c}, y_{c}). It may be understood that when height deviations between the three calibration marks m₁, m₂ and m₃ and the preset position in the y-axis direction are the same, that is, when yₘ₁ - y_{c}, yₘ₂ - y_{c} and yₘ₃ - Y_{c} have the same numeric value and the same positive or negative property, it may be determined that the calibration plane is parallel to the horizontal plane, and thus it may be determined that the picking surface parallel to the calibration plane is also parallel to the horizontal plane.

The driving unit may also drive the mobile unit to rotate counter-clockwise, to ensure the aligner to rotate to be able to acquire the second image including the second calibration mark and the third image including the third calibration mark. Selections may be made by those skilled in the art according to actual bonding requirements, which are not further limited here by the present disclosure.

The first angle and the second angle may be determined according to a manner of providing the calibration marks m₁, m₂ and m₃. In a practical application, the bonding head may have a cylindrical shape, and each of the picking surface and the calibration plane may have a circular shape. The first angle may be determined based on a central angle formed by the calibration mark m₁, the calibration mark m₂ and center of the calibration plane, and the second angle may be determined based on a central angle formed by the calibration mark m₂, the calibration mark m₃ and the center of the calibration plane.

For example, when the calibration marks m₁, m₂ and m₃ may be arranged on the side surface 301c at equal intervals, each of the first angle and the second angle is 120°. When a line connecting the calibration marks m₁ and m₃ passes through the center of the calibration plane, and a line connecting the calibration mark m₂ and the center of the calibration plane is perpendicular to the line connecting the calibration marks m₁ and m₃, each of the first angle and the second angle is 90°.

Although only the calibration marks m₁, m₂ and m₃ on the side surface 301c are shown in this example, the calibration marks m₁, m₂ and m₃ may be located on the top surface 301a in other examples, for example, on a boundary line of the top surface 301a. The number of the calibration marks on the side surface 301c or the top surface 301a is not limited to three, there may also be four, five or more calibration marks, which are not limited here by the present disclosure.

In the embodiments of the present disclosure, at least three calibration marks are arranged on the side surface or the top surface of the bonding head, a plane where three calibration marks are located is parallel to the picking surface, and the offset of the calibration plane with respect to the horizontal plane may be determined by determining sub-deviations between the three calibration marks and the preset position, and thus the offset of the picking surface parallel to the calibration plane with respect to the horizontal plane is determined.

In some embodiments, the bonding head may include a side surface perpendicular to the picking surface, a top surface parallel to the picking surface, and at least three calibration marks, here the at least three calibration marks are located on the side surface or the top surface, and a plane where the at least three calibration marks are located is parallel to the picking surface.

Determining the offset of the picking surface of the bonding head with respect to the horizontal plane may include the following operations.

Sub-deviations between the at least three calibration marks and a preset position are acquired simultaneously.

The offset is determined according to the at least three sub-deviations.

Exemplarily, with reference to FIG. 5A and FIG. 10A, the first alignment assembly 304' may include three aligners 3041' and three second optical paths 306'.

Specifically, a first aligner 3041' and a 1^{st} second optical path 306' are located at a right side of the first calibration mark m₁, to acquire the sub-deviation between the first calibration mark m₁ and the preset position.

A second aligner 3041' and a 2^{nd} second optical path 306' are located at a side of the second calibration mark m₂ facing the positive direction of the y-axis, to acquire the sub-deviation between the second calibration mark m₂ and the preset position.

A third aligner 3041' and a 3 third optical path 306' are located at a left side of the third calibration mark m₃, to acquire the sub-deviation between the third calibration mark m₃ and the preset position.

The first alignment assembly 304' determines the offset of the picking surface 301b with respect to the horizontal plane, according to the three sub-deviations.

It is to be noted that a scenario where the bonding head includes three calibration marks and the first alignment assembly includes three aligners, is shown in this example. In other examples, the bonding head may include at least four calibration marks, and the first alignment assembly may include at least four aligners. The number or positions of arranging the calibration marks in the bonding head are not limited here by the present disclosure, and it is only required to ensure that the plane where the calibration marks are arranged is parallel to the picking surface.

Compared with acquiring the first image, the second image and the third image of the three calibration marks sequentially, in the embodiments of the present disclosure, sub-deviations between at least three calibration marks and the preset position may be acquired without driving the bonding head to rotate, which is conducive to improving accuracy of three sub-deviations.

Furthermore, in the embodiments of the present disclosure, three sub-deviations may be acquired simultaneously, which may shorten the time for determining the offset, and thus shorten the time for levelness detection and horizontal adjustment before die to wafer bonding, improving bonding efficiency.

In some embodiments, the bonding head may include a side surface perpendicular to the picking surface, and at least two calibration optical paths penetrating the bonding head from the side surface, here a plane where the at least two calibration optical paths are located is parallel to the picking surface.

Determining the offset of the picking surface of the bonding head with respect to the horizontal plane may include the following operations.

A calibration optical signal is transmitted to an end of a first one of the calibration optical paths.

A first sub-offset is determined according to a received calibration optical signal transmitted through the first one of the calibration optical paths.

The bonding head is driven to rotate after determining the first sub-offset.

A calibration optical signal is transmitted to an end of a second one of the calibration optical paths after the bonding head rotates.

A second sub-offset is determined according to a received calibration optical signal transmitted through the second one of the calibration optical paths.

The offset is determined according to the first sub-offset and the second sub-offset.

Exemplarily, with reference to FIG. 4A and FIG. 4B, two calibration optical paths 3111 and 3112 pass through the bonding head 301 from the side surface 301c, and a plane formed by the two calibration optical paths 3111 and 3112 is marked as a calibration plane which is parallel to the picking surface 301b.

When the bonding head 301 is located at the first position, the transmission unit 3042 transmits the calibration optical signal to the first calibration optical path 3111. The receiving unit 3043 may determine the first sub-offset according to intensity I₁ of the transmitted calibration optical signal and intensity I₁' of a received calibration optical signal.

The driving unit drives the bonding head 301 to rotate until the second calibration optical path 3112 is aligned with the transmission unit 3042. The transmission unit 3042 transmits the calibration optical signal to the second calibration optical path 3112. The receiving unit 3043 may determine the second sub-offset according to intensity I₂ of the transmitted calibration optical signal and intensity I₂' of a received calibration optical signal. The first alignment assembly may determine the offset of the picking surface 301b with respect to the horizontal plane according to the first sub-offset and the second sub-offset.

Although only two calibration optical paths 3111 and 3112 are shown in this example, the number of calibration optical paths penetrating the bonding head 301 from the side surface 301c in other examples is not limited to two, there may be three or more calibration optical paths, which are not limited here by the present disclosure, and it is only required to ensure that the calibration optical paths do not overlap with the first optical path 302.

In some embodiments, the bonding head may include a side surface perpendicular to the picking surface, and at least two calibration optical paths penetrating the bonding head from the side surface, here a plane where the at least two calibration optical paths are located is parallel to the picking surface.

Determining the offset of the picking surface of the bonding head with respect to the horizontal plane may include the following operations.

A calibration optical signal is transmitted to an end of a first one of the calibration optical paths, and a calibration optical signal is transmitted to an end of a second one of the calibration optical paths.

A first sub-offset is determined according to a received calibration optical signal transmitted through the first one of the calibration optical paths.

A second sub-offset is determined according to a received calibration optical signal transmitted through the second one of the calibration optical paths.

The offset is determined according to the first sub-offset and the second sub-offset.

Exemplarily, with reference to FIG. 4A and FIG. 4B, the first alignment assembly 304 may include two transmission units 3042 and two receiving units 3043.

Specifically, the first transmission unit 3042 and the first receiving unit 3043 are arranged in parallel along the x direction and are located at two sides of the first calibration optical path 3111 which are arranged opposite to each other in the x direction respectively, to determine the first sub-offset.

The second transmission unit 3042 and the second receiving unit 3043 are arranged in parallel along the x direction and are located at two sides of the second calibration optical path 3112 which are arranged opposite to each other in the x direction respectively, to determine the second sub-offset.

The first alignment assembly 304 may determine the offset of the picking surface 301b with respect to the horizontal plane according to the first sub-offset and the second sub-offset.

FIG. 11 shows a schematic view of a die to wafer structure according to an embodiment of the present disclosure. The die to wafer structure is manufactured by applying the bonding system 300 in any of the above embodiments and the bonding method in any of the above embodiments, and includes multiple first dies 11 and a wafer 20.

The wafer 20 includes multiple second dies 21, here each first die 11 is bonded to each second die 21.

It is apparent that the above embodiments are merely examples made for clear explanation, rather than limiting the implementations. Other changes or variations in different forms may also be made by those ordinary skilled in the art based on the above descriptions. It is unnecessary and impossible to enumerate all the implementations here. Apparent changes or variations arising therefrom still fall within the scope of protection of the present application as defined by the appended claims.

## Claims

1. A bonding system (300) comprising:
a bonding assembly comprising a bonding head (301) and a first optical path (302) penetrating the bonding head (301), wherein a first end (302a) of the first optical path (302) is located at a picking surface (301b) where the bonding head (301) picks a first to-be-bonded die (11);
a wafer stage (303) configured to carry a wafer (20);
a first alignment assembly (304) configured to determine an offset of the picking surface (301b) with respect to a horizontal plane when the bonding head (301) is located at a first position;
wherein the bonding assembly is further configured to drive, according to the offset, the bonding head (301) to move to a second position parallel to the horizontal plane;
the first alignment assembly (304) is further configured to transmit a detection optical signal to the first end (302a) via a second end of the first optical path (302) when the bonding head (301) is located at the second position, wherein the picked first to-be-bonded die (11) covers the first end (302a) and reflects the detection optical signal;
the first alignment assembly (304) is further configured to receive a reflection optical signal generated by the first to-be-bonded die (11) reflecting the detection optical signal, and determine a first deviation value between a current position of the first to-be-bonded die (11) and a first target position according to the received reflection optical signal;
a second alignment assembly (305) located at a side of the wafer stage (303) away from the bonding assembly, and configured to determine a second deviation value between a current position of a second to-be-bonded die (21) on the wafer (20) and a second target position;
wherein the wafer stage (303) is further configured to drive, according to the first deviation value and the second deviation value, the carried wafer (20) to move relative to the picking surface (301b), to align the second to-be-bonded die (21) with the first to-be-bonded die (11); or the bonding assembly is further configured to drive, according to the first deviation value and the second deviation value, the picking surface (301b) where the first to-be-bonded die (11) is picked to move relative to the wafer stage (303), to align the first to-be-bonded die (11) with the second to-be-bonded die (21);
the bonding assembly is further configured to bond the first to-be-bonded die (11) to the second to-be-bonded die (21).

2. The bonding system (300) of claim 1, wherein
the bonding head (301) comprises a side surface perpendicular to the picking surface (301b), a top surface parallel to the picking surface (301b), and at least three calibration marks, wherein the at least three calibration marks are located on the side surface or the top surface, and a plane where the at least three calibration marks are located is parallel to the picking surface (301b);
the first alignment assembly (304) is specifically configured to determine the offset according to sub-deviations between the at least three calibration marks and a preset position.

3. The bonding system (300) of claim 2, wherein
the at least three calibration marks comprise a first calibration mark, a second calibration mark, a third calibration mark,
the first alignment assembly (304) is specifically configured to acquire a first image comprising the first calibration mark when the bonding head (301) is located at the first position, and determine a first sub-deviation between a position of the first calibration mark and the preset position according to the first image;
the bonding assembly is further configured to drive the bonding head (301) to rotate by a first angle, to enable the first alignment assembly (304) to acquire a second image comprising the second calibration mark;
the first alignment assembly (304) is specifically further configured to determine a second sub-deviation between a position of the second calibration mark and the preset position according to the acquired second image;
the bonding assembly is further configured to drive the bonding head (301) to rotate by a second angle, to enable the first alignment assembly (304) to acquire a third image comprising the third calibration mark;
the first alignment assembly (304) is specifically further configured to determine a third sub-deviation between a position of the third calibration mark and the preset position according to the acquired third image, and determine the offset according to the first sub-deviation, the second sub-deviation and the third sub-deviation.

4. The bonding system (300) of claim 2, wherein
the first alignment assembly (304) comprises at least three aligners, each aligner configured to acquire a sub-deviation between one of the calibration marks and the preset position;
the first alignment assembly (304) is specifically configured to determine the offset according to the at least three sub-deviations.

5. The bonding system (300) of claim 1, wherein
the bonding head (301) comprises a side surface perpendicular to the picking surface (301b), and at least two calibration optical paths penetrating the bonding head (301) from the side surface, wherein a plane where the at least two calibration optical paths are located is parallel to the picking surface (301b);
the first alignment assembly (304) is specifically configured to determine the offset according to sub-offsets between the at least two calibration optical paths and the horizontal plane.

6. The bonding system (300) of claim 5, wherein
the at least two calibration optical paths comprise a first calibration optical path and a second calibration optical path,
the first alignment assembly (304) comprises a transmission unit and a receiving unit,
wherein when the bonding head (301) is located at the first position, the transmission unit is aligned with an end of the first calibration optical path, and the receiving unit is aligned with at least a part of area of another end of the first calibration optical path; the transmission unit is configured to transmit a calibration optical signal to the end of the first calibration optical path; the receiving unit is configured to determine a first sub-offset according to a received calibration optical signal transmitted through the first calibration optical path;
the bonding assembly is further configured to drive the bonding head (301) to rotate, to enable an end of the second calibration optical path to be aligned with the transmission unit, wherein the receiving unit is aligned with at least a part of area of another end of the second calibration optical path;
the transmission unit is further configured to transmit a calibration optical signal to the end of the second calibration optical path; the receiving unit is further configured to determine a second sub-offset according to a received calibration optical signal transmitted through the second calibration optical path;
the first alignment assembly (304) is specifically configured to determine the offset according to the first sub-offset and the second sub-offset.

7. The bonding system (300) of claim 5, wherein
the first alignment assembly (304) comprises a first transmission unit and a second transmission unit, and a first receiving unit and a second receiving unit,
the at least two calibration optical paths comprise a first calibration optical path and a second calibration optical path,
wherein when the bonding head (301) is located at the first position, the first transmission unit is aligned with an end of the first calibration optical path, and the first receiving unit is aligned with at least a part of area of another end of the first calibration optical path; a second transmission unit is aligned with an end of the second calibration optical path, and the second receiving unit is aligned with at least a part of area of another end of the second calibration optical path;
the first transmission unit is configured to transmit a calibration optical signal to the end of the first calibration optical path;
the first receiving unit is configured to determine a first sub-offset according to a received calibration optical signal transmitted through the first calibration optical path;
the second transmission unit is configured to transmit a calibration optical signal to the end of the second calibration optical path;
the second receiving unit is configured to determine a second sub-offset according to a received calibration optical signal transmitted through the second calibration optical path;
the first alignment assembly (304) is specifically configured to determine the offset according to the first sub-offset and the second sub-offset.

8. A bonding method, applied to bonding a first to-be-bonded die to a second to-be-bonded die on a wafer, **characterized by** comprising:
when a bonding head picking the first to-be-bonded die is located at a first position, determining (S100) an offset of a picking surface where the bonding head picks the first to-be-bonded die with respect to a horizontal plane;
driving (S200), according to the offset, the bonding head to move to a second position parallel to the horizontal plane;
when the bonding head is located at the second position, transmitting a detection optical signal, receiving a reflection optical signal generated by the first to-be-bonded die reflecting the detection optical signal, determining (S300), according to the received reflection optical signal, a first deviation value between a current position of the picked first to-be-bonded die and a first target position, and determining a second deviation value between a current position of the second to-be-bonded die and a second target position;
moving (S400) the wafer or the first to-be-bonded die according to the first deviation value and the second deviation value, to align the first to-be-bonded die with the second to-be-bonded die; and
bonding (S500) the first to-be-bonded die to the second to-be-bonded die, after aligning the first to-be-bonded die with the second to-be-bonded die.

9. The bonding method of claim 8, wherein the bonding head comprises a side surface perpendicular to the picking surface, a top surface parallel to the picking surface, and at least three calibration marks, wherein the at least three calibration marks are located on the side surface or the top surface and comprise a first calibration mark, a second calibration mark and a third calibration mark, and a plane where the at least three calibration marks are located is parallel to the picking surface;
determining the offset of the picking surface of the bonding head with respect to the horizontal plane comprises:
acquiring a first image comprising the first calibration mark;
determining a first sub-deviation between a position of the first calibration mark and the preset position according to the first image;
driving the bonding head to rotate by a first angle after acquiring the first image;
acquiring a second image comprising the second calibration mark after the bonding head rotates by the first angle;
determining a second sub-deviation between a position of the second calibration mark and the preset position according to the second image;
driving the bonding head to rotate by a second angle after acquiring the second image;
acquiring a third image comprising the third calibration mark after the bonding head rotates by the second angle;
determining a third sub-deviation between a position of the third calibration mark and the preset position according to the third image; and
determining the offset according to the first sub-deviation, the second sub-deviation and the third sub-deviation.

10. The bonding method of claim 8, wherein the bonding head comprises a side surface perpendicular to the picking surface, a top surface parallel to the picking surface, and at least three calibration marks, wherein the at least three calibration marks are located on the side surface or the top surface, and a plane where the at least three calibration marks are located is parallel to the picking surface;
determining the offset of the picking surface of the bonding head with respect to the horizontal plane comprises:
acquiring sub-deviations between the at least three calibration marks and a preset position simultaneously; and
determining the offset according to the at least three sub-deviations.

11. The bonding method of claim 8, wherein the bonding head comprises a side surface perpendicular to the picking surface, and at least two calibration optical paths penetrating the bonding head from the side surface, wherein a plane where the at least two calibration optical paths are located is parallel to the picking surface, the at least two calibration optical paths comprise a first calibration optical path and a second calibration optical path;
determining the offset of the picking surface of the bonding head with respect to the horizontal plane comprises:
transmitting a calibration optical signal to an end of the first calibration optical path;
determining a first sub-offset according to a received calibration optical signal transmitted through the first calibration optical path;
driving the bonding head to rotate after determining the first sub-offset;
transmitting a calibration optical signal to an end of the second calibration optical path after the bonding head rotates;
determining a second sub-offset according to a received calibration optical signal transmitted through the second calibration optical path; and
determining the offset according to the first sub-offset and the second sub-offset.

12. The bonding method of claim 8, wherein the bonding head comprises a side surface perpendicular to the picking surface, and at least two calibration optical paths penetrating the bonding head from the side surface, wherein a plane where the at least two calibration optical paths are located is parallel to the picking surface, the at least two calibration optical paths comprise a first calibration optical path and a second calibration optical path;
determining the offset of the picking surface of the bonding head with respect to the horizontal plane comprises:
transmitting a calibration optical signal to an end of the first calibration optical path, and transmitting a calibration optical signal to an end of the second calibration optical path;
determining a first sub-offset according to a received calibration optical signal transmitted through the first calibration optical path;
determining a second sub-offset according to a received calibration optical signal transmitted through the second calibration optical path; and
determining the offset according to the first sub-offset and the second sub-offset.

## Patentansprüche

1. Ein Verbindungssystem (300), umfassend:
eine Verbindungsanordnung, die einen Verbindungskopf (301) und einen ersten optischen Pfad (302), der den Verbindungskopf (301) durchdringt, umfasst, wobei sich ein erstes Ende (302a) des ersten optischen Pfads (302) an einer Aufnahmefläche (301b) befindet, wo der Verbindungskopf (301) einen ersten zu verbindenden Die (11) aufnimmt;
eine Waferplattform (303), die zum Tragen eines Wafers (20) konfiguriert ist;
eine erste Ausrichtungsanordnung (304), die dazu konfiguriert ist, einen Versatz der Aufnahmefläche (301b) in Bezug auf eine horizontale Ebene zu bestimmen, wenn sich der Verbindungskopf (301) an einer ersten Position befindet;
wobei die Verbindungsanordnung weiter dazu konfiguriert ist, den Verbindungskopf (301) gemäß dem Versatz anzutreiben, sich in eine zweite Position parallel zu der horizontalen Ebene zu bewegen;
die erste Ausrichtungsanordnung (304) weiter dazu konfiguriert ist, ein optisches Detektionssignal über ein zweites Ende des ersten optischen Pfads (302) an das erste Ende (302a) zu übertragen, wenn sich der Verbindungskopf (301) an der zweiten Position befindet, wobei der aufgenommene erste zu verbindende Die (11) das erste Ende (302a) bedeckt und das optische Detektionssignal reflektiert;
die erste Ausrichtungsanordnung (304) weiter dazu konfiguriert ist, ein optisches Reflexionssignal zu empfangen, das von dem ersten zu verbindenden Die (11) erzeugt wird, der das optische Detektionssignal reflektiert, und einen ersten Abweichungswert zwischen einer aktuellen Position des ersten zu verbindenden Dies (11) und einer ersten Zielposition gemäß dem empfangenen optischen Reflexionssignal zu bestimmen;
eine zweite Ausrichtungsanordnung (305), die sich an einer von der Verbindungsanordnung entfernten Seite der Waferplattform (303) befindet und dazu konfiguriert ist, einen zweiten Abweichungswert zwischen einer aktuellen Position eines zweiten zu verbindenden Dies (21) auf dem Wafer (20) und einer zweiten Zielposition zu bestimmen;
wobei die Waferplattform (303) weiter dazu konfiguriert ist, den getragenen Wafer (20) gemäß dem ersten Abweichungswert und dem zweiten Abweichungswert anzutreiben, sich relativ zu der Aufnahmefläche (301b) zu bewegen und so den zweiten zu verbindenden Die (21) mit dem ersten zu verbindenden Die (11) auszurichten; oder die Verbindungsanordnung weiter dazu konfiguriert ist, die Aufnahmefläche (301b), auf der der erste zu verbindende Die (11) aufgenommen ist, gemäß dem ersten Abweichungswert und dem zweiten Abweichungswert anzutreiben, sich relativ zu der Waferplattform (303) zu bewegen, um den ersten zu verbindenden Die (11) mit dem zweiten zu verbindenden Die (21) auszurichten;
die Verbindungsanordnung weiter dazu konfiguriert ist, den ersten zu verbindenden Die (11) mit dem zweiten zu verbindenden Die (21) zu verbinden.

2. Das Verbindungsverfahren (300) nach Anspruch 1, wobei
der Verbindungskopf (301) eine Seitenfläche senkrecht zu der Aufnahmefläche (301b), eine Deckfläche parallel zu der Aufnahmefläche (301b) und mindestens drei Kalibrierungsmarkierungen umfasst, wobei sich die mindestens drei Kalibrierungsmarkierungen auf der Seitenfläche oder der Deckfläche befinden und eine Ebene, auf der sich die mindestens drei Kalibrierungsmarkierungen befinden, parallel zu der Aufnahmefläche (301b) ist;
die erste Ausrichtungsanordnung (304) insbesondere dazu konfiguriert ist, den Versatz gemäß Teilabweichungen zwischen den mindestens drei Kalibrierungsmarkierungen und einer vorgegebenen Position zu bestimmen.

3. Das Verbindungssystem (300) nach Anspruch 2, wobei
die mindestens drei Kalibrierungsmarkierungen eine erste Kalibrierungsmarkierung, eine zweite Kalibrierungsmarkierung und eine dritte Kalibrierungsmarkierung umfassen,
die erste Ausrichtungsanordnung (304) insbesondere dazu konfiguriert ist, ein erstes Bild zu erfassen, das die erste Kalibrierungsmarkierung umfasst, wenn sich der Verbindungskopf (301) an der ersten Position befindet, und eine erste Teilabweichung zwischen einer Position der ersten Kalibrierungsmarkierung und der vorgegebenen Position gemäß dem ersten Bild zu bestimmen;
die Verbindungsanordnung weiter dazu konfiguriert ist, den Verbindungskopf (301) anzutreiben, sich um einen ersten Winkel zu drehen, um der ersten Ausrichtungsanordnung (304) zu ermöglichen, ein zweites Bild zu erfassen, das die zweite Kalibrierungsmarkierung umfasst;
die erste Ausrichtungsanordnung (304) insbesondere weiter dazu konfiguriert ist, eine zweite Teilabweichung zwischen einer Position der zweiten Kalibrierungsmarkierung und der vorgegebenen Position gemäß dem erfassten zweiten Bild zu bestimmen;
die Verbindungsanordnung weiter dazu konfiguriert ist, den Verbindungskopf (301) anzutreiben, sich um einen zweiten Winkel zu drehen, um der ersten Ausrichtungsanordnung (304) zu ermöglichen, ein drittes Bild zu erfassen, das die dritte Kalibrierungsmarkierung umfasst;
die erste Ausrichtungsanordnung (304) insbesondere weiter dazu konfiguriert ist, eine dritte Teilabweichung zwischen einer Position der dritten Kalibrierungsmarkierung und der vorgegebenen Position gemäß dem erfassten dritten Bild zu bestimmen und den Versatz gemäß der ersten Teilabweichung, der zweiten Teilabweichung und der dritten Teilabweichung zu bestimmen.

4. Das Verbindungssystem (300) nach Anspruch 2, wobei
die erste Ausrichtungsanordnung (304) mindestens drei Ausrichter umfasst, wobei jeder Ausrichter dazu konfiguriert ist, eine Teilabweichung zwischen einer der Kalibrierungsmarkierungen und der vorgegebenen Position zu erfassen;
die erste Ausrichtungsanordnung (304) insbesondere dazu konfiguriert ist, den Versatz gemäß den mindestens drei Teilabweichungen zu bestimmen.

5. Das Verbindungsverfahren (300) nach Anspruch 1, wobei
der Verbindungskopf (301) eine Seitenfläche senkrecht zu der Aufnahmefläche (301b) und mindestens zwei optische Kalibrierungspfade, die den Verbindungskopf (301) von der Seitenfläche aus durchdringen, umfasst, wobei eine Ebene, in der sich die mindestens zwei optischen Kalibrierungspfade befinden, parallel zu der Aufnahmefläche (301b) ist;
die erste Ausrichtungsanordnung (304) insbesondere dafür konfiguriert ist, den Versatz gemäß Teilversätzen zwischen den mindestens zwei optischen Kalibrierungspfaden und der horizontalen Ebene zu bestimmen.

6. Das Verbindungssystem (300) nach Anspruch 5, wobei
die mindestens zwei optischen Kalibrierungspfade einen ersten optischen Kalibrierungspfad und einen zweiten optischen Kalibrierungspfad umfassen,
die erste Ausrichtungsanordnung (304) eine Übertragungseinheit und eine Empfangseinheit umfasst,
wobei, wenn sich der Verbindungskopf (301) an der ersten Position befindet, die Übertragungseinheit mit einem Ende des ersten optischen Kalibrierungspfads ausgerichtet ist und die Empfangseinheit mit mindestens einem Teilbereich eines anderen Endes des ersten optischen Kalibrierungspfads ausgerichtet ist; die Übertragungseinheit dazu konfiguriert ist, ein optisches Kalibrierungssignal an das Ende des ersten optischen Kalibrierungspfads zu übertragen; die Empfangseinheit dazu konfiguriert ist, einen ersten Teilversatz gemäß einem empfangenen optischen Kalibrierungssignal zu bestimmen, das über den ersten optischen Kalibrierungspfad übertragen wird;
die Verbindungsanordnung weiter dazu konfiguriert ist, den Verbindungskopf (301) anzutreiben, sich zu drehen, um einem Ende des zweiten optischen Kalibrierungspfads zu ermöglichen, mit der Übertragungseinheit ausgerichtet zu werden, wobei die Empfangseinheit mit mindestens einem Teilbereich eines anderen Endes des zweiten optischen Kalibrierungspfads ausgerichtet ist;
die Übertragungseinheit weiter dazu konfiguriert ist, ein optisches Kalibrierungssignal an das Ende des zweiten optischen Kalibrierungspfads zu übertragen; die Empfangseinheit weiter dazu konfiguriert ist, einen zweiten Teilversatz gemäß einem empfangenen optischen Kalibrierungssignal zu bestimmen, das über den zweiten optischen Kalibrierungspfad übertragen wird;
die erste Ausrichtungsanordnung (304) insbesondere dazu konfiguriert ist, den Versatz gemäß dem ersten Teilversatz und dem zweiten Teilversatz zu bestimmen.

7. Das Verbindungssystem (300) nach Anspruch 5, wobei
die erste Ausrichtungsanordnung (304) eine erste Übertragungseinheit und eine zweite Übertragungseinheit und eine erste Empfangseinheit und eine zweite Empfangseinheit umfasst,
die mindestens zwei optischen Kalibrierungspfade einen ersten optischen Kalibrierungspfad und einen zweiten optischen Kalibrierungspfad umfassen,
wobei, wenn sich der Verbindungskopf (301) an der ersten Position befindet, die erste Übertragungseinheit mit einem Ende des ersten optischen Kalibrierungspfads ausgerichtet ist und die erste Empfangseinheit mit mindestens einem Teilbereich eines anderen Endes des ersten optischen Kalibrierungspfads ausgerichtet ist; eine zweite Übertragungseinheit mit einem Ende des zweiten optischen Kalibrierungspfads ausgerichtet ist und die zweite Empfangseinheit mit mindestens einem Teilbereich eines anderen Endes des zweiten optischen Kalibrierungspfads ausgerichtet ist;
die erste Übertragungseinheit dazu konfiguriert ist, ein optisches Kalibrierungssignal an das Ende des ersten optischen Kalibrierungspfads zu übertragen;
die erste Empfangseinheit dazu konfiguriert ist, einen ersten Teilversatz gemäß einem empfangenen optischen Kalibrierungssignal zu bestimmen, das über den ersten optischen Kalibrierungspfad übertragen wird;
die zweite Übertragungseinheit dazu konfiguriert ist, ein optisches Kalibrierungssignal an das Ende des zweiten optischen Kalibrierungspfads zu übertragen;
die zweite Empfangseinheit dazu konfiguriert ist, einen zweiten Teilversatz gemäß einem empfangenen optischen Kalibrierungssignal zu bestimmen, das über den zweiten optischen Kalibrierungspfad übertragen wird;
die erste Ausrichtungsanordnung (304) insbesondere dazu konfiguriert ist, den Versatz gemäß dem ersten Teilversatz und dem zweiten Teilversatz zu bestimmen.

8. Ein Verbindungsverfahren, das zum Verbinden eines ersten zu verbindenden Dies mit einem zweiten zu verbindenden Die auf einem Wafer angewendet wird, **dadurch gekennzeichnet, dass** es Folgendes umfasst:
wenn sich ein Verbindungskopf, der den ersten zu verbindenden Die aufnimmt, an einer ersten Position befindet, Bestimmen (S100) eines Versatzes einer Aufnahmefläche, an der der Verbindungskopf den ersten zu verbindenden Die aufnimmt, in Bezug auf eine horizontale Ebene;
Antreiben (S200) des Verbindungskopfs gemäß dem Versatz, sich in eine zweite Position parallel zu der horizontalen Ebene zu bewegen;
wenn sich der Verbindungskopf an der zweiten Position befindet, Übertragen eines optischen Detektionssignals, Empfangen eines optischen Reflexionssignals, das von dem ersten zu verbindenden Die erzeugt wird, der das optische Detektionssignal reflektiert, Bestimmen (S300) eines ersten Abweichungswerts zwischen einer aktuellen Position des aufgenommenen ersten zu verbindenden Dies und einer ersten Zielposition gemäß dem empfangenen optischen Reflexionssignal, und Bestimmen eines zweiten Abweichungswerts zwischen einer aktuellen Position des zweiten zu verbindenden Dies und einer zweiten Zielposition;
Bewegen (S400) des Wafers oder des ersten zu verbindenden Dies gemäß dem ersten Abweichungswert und dem zweiten Abweichungswert, um den ersten zu verbindenden Die mit dem zweiten zu verbindenden Die auszurichten; und
Verbinden (S500) des ersten zu verbindenden Dies mit dem zweiten zu verbindenden Die, nachdem der erste zu verbindende Die mit dem zweiten zu verbindenden Die ausgerichtet wurde.

9. Das Verbindungsverfahren nach Anspruch 8, wobei der Verbindungskopf eine Seitenfläche senkrecht zu der Aufnahmefläche, eine Deckfläche parallel zu der Aufnahmefläche und mindestens drei Kalibrierungsmarkierungen umfasst, wobei sich die mindestens drei Kalibrierungsmarkierungen auf der Seitenfläche oder der Deckfläche befinden und eine erste Kalibrierungsmarkierung, eine zweite Kalibrierungsmarkierung und eine dritte Kalibrierungsmarkierung umfassen, und eine Ebene, auf der sich die mindestens drei Kalibrierungsmarkierungen befinden, parallel zu der Aufnahmefläche ist;
Bestimmen des Versatzes der Aufnahmefläche des Verbindungskopfs in Bezug auf die horizontale Ebene umfasst:
Erfassen eines ersten Bilds, das die erste Kalibrierungsmarkierung umfasst;
Bestimmen einer ersten Teilabweichung zwischen einer Position der ersten Kalibrierungsmarkierung und der vorgegebenen Position gemäß dem ersten Bild;
Antreiben des Verbindungskopfs, sich nach Erfassen des ersten Bilds um einen ersten Winkel zu drehen;
Erfassen eines zweiten Bilds, das die zweite Kalibrierungsmarkierung umfasst, nachdem sich der Verbindungskopf um den ersten Winkel gedreht hat;
Bestimmen einer zweiten Teilabweichung zwischen einer Position der zweiten Kalibrierungsmarkierung und der vorgegebenen Position gemäß dem zweiten Bild;
Antreiben des Verbindungskopfs, sich nach Erfassen des zweiten Bilds um einen zweiten Winkel zu drehen;
Erfassen eines dritten Bilds, das die dritte Kalibrierungsmarkierung umfasst, nachdem sich der Verbindungskopf um den zweiten Winkel gedreht hat;
Bestimmen einer dritten Teilabweichung zwischen einer Position der dritten Kalibrierungsmarkierung und der vorgegebenen Position gemäß dem dritten Bild; und
Bestimmen des Versatzes gemäß der ersten Teilabweichung, der zweiten Teilabweichung und der dritten Teilabweichung.

10. Das Verbindungsverfahren nach Anspruch 8, wobei der Verbindungskopf eine Seitenfläche senkrecht zu der Aufnahmefläche, eine Deckfläche parallel zu der Aufnahmefläche und mindestens drei Kalibrierungsmarkierungen umfasst, wobei sich die mindestens drei Kalibrierungsmarkierungen auf der Seitenfläche oder der Deckfläche befinden und eine Ebene, auf der sich die mindestens drei Kalibrierungsmarkierungen befinden, parallel zu der Aufnahmefläche ist;
Bestimmen des Versatzes der Aufnahmefläche des Verbindungskopfs in Bezug auf die horizontale Ebene umfasst:
gleichzeitiges Erfassen von Teilabweichungen zwischen den mindestens drei Kalibrierungsmarkierungen und einer vorgegebenen Position; und
Bestimmen des Versatzes gemäß den mindestens drei Teilabweichungen.

11. Das Verbindungsverfahren nach Anspruch 8, wobei der Verbindungskopf eine Seitenfläche senkrecht zu der Aufnahmefläche und mindestens zwei optische Kalibrierungspfade, die den Verbindungskopf von der Seitenfläche aus durchdringen, umfasst, wobei eine Ebene, in der sich die mindestens zwei optischen Kalibrierungspfade befinden, parallel zu der Aufnahmefläche ist, die mindestens zwei optischen Kalibrierungspfade einen ersten optischen Kalibrierungspfad und einen zweiten optischen Kalibrierungspfad umfassen;
Bestimmen des Versatzes der Aufnahmefläche des Verbindungskopfs in Bezug auf die horizontale Ebene umfasst:
Übertragen eines optischen Kalibrierungssignals an ein Ende des ersten optischen Kalibrierungspfads;
Bestimmen eines ersten Teilversatzes gemäß einem empfangenen optischen Kalibrierungssignal, das über den ersten optischen Kalibrierungspfad übertragen wird;
Antreiben des Verbindungskopfs, sich nach Bestimmen des ersten Teilversatzes zu drehen;
Übertragen eines optischen Kalibrierungssignals an ein Ende des zweiten optischen Kalibrierungspfads, nachdem sich der Verbindungskopf gedreht hat;
Bestimmen eines zweiten Teilversatzes gemäß einem empfangenen optischen Kalibrierungssignal, das über den zweiten optischen Kalibrierungspfad übertragen wird; und
Bestimmen des Versatzes gemäß dem ersten Teilversatz und dem zweiten Teilversatz.

12. Das Verbindungsverfahren nach Anspruch 8, wobei der Verbindungskopf eine Seitenfläche senkrecht zu der Aufnahmefläche und mindestens zwei optische Kalibrierungspfade, die den Verbindungskopf von der Seitenfläche aus durchdringen, umfasst, wobei eine Ebene, in der sich die mindestens zwei optischen Kalibrierungspfade befinden, parallel zu der Aufnahmefläche ist, die mindestens zwei optischen Kalibrierungspfade einen ersten optischen Kalibrierungspfad und einen zweiten optischen Kalibrierungspfad umfassen;
Bestimmen des Versatzes der Aufnahmefläche des Verbindungskopfs in Bezug auf die horizontale Ebene umfasst:
Übertragen eines optischen Kalibrierungssignals an ein Ende des ersten optischen Kalibrierungspfads und Übertragen eines optischen Kalibrierungssignals an ein Ende des zweiten optischen Kalibrierungspfads;
Bestimmen eines ersten Teilversatzes gemäß einem empfangenen optischen Kalibrierungssignal, das über den ersten optischen Kalibrierungspfad übertragen wird;
Bestimmen eines zweiten Teilversatzes gemäß einem empfangenen optischen Kalibrierungssignal, das über den zweiten optischen Kalibrierungspfad übertragen wird; und
Bestimmen des Versatzes gemäß dem ersten Teilversatz und dem zweiten Teilversatz.

## Revendications

1. Un système de liaison (300) comprenant :
un ensemble de liaison comprenant une tête de liaison (301) et un premier chemin optique (302) pénétrant dans la tête de liaison (301), dans lequel une première extrémité (302a) du premier chemin optique (302) est située au niveau d'une surface de prélèvement (301b) où la tête de liaison (301) prélève une première puce à lier (11) ;
un étage de plaquette (303) configuré pour porter une plaquette (20) ;
un premier ensemble d'alignement (304) configuré pour déterminer un décalage de la surface de prélèvement (301b) par rapport à un plan horizontal lorsque la tête de liaison (301) est située à une première position ;
dans lequel l'ensemble de liaison est en outre configuré pour entraîner, en fonction du décalage, la tête de liaison (301) à se déplacer vers une deuxième position parallèle au plan horizontal ;
le premier ensemble d'alignement (304) est en outre configuré pour transmettre un signal optique de détection à la première extrémité (302a) via une deuxième extrémité du premier chemin optique (302) lorsque la tête de liaison (301) est située à la deuxième position, dans laquelle la première puce à lier (11) prélevée recouvre la première extrémité (302a) et réfléchit le signal optique de détection ;
le premier ensemble d'alignement (304) est en outre configuré pour recevoir un signal optique de réflexion généré par la première puce à lier (11) réfléchissant le signal optique de détection, et déterminer une première valeur d'écart entre une position actuelle de la première puce à lier (11) et une première position cible en fonction du signal optique de réflexion reçu ;
un deuxième ensemble d'alignement (305) situé sur un côté de l'étage de plaquette (303) éloigné de l'ensemble de liaison, et configuré pour déterminer une deuxième valeur d'écart entre une position actuelle d'une deuxième puce à lier (21) sur la plaquette (20) et une deuxième position cible ;
dans lequel l'étage de plaquette (303) est en outre configuré pour entraîner, en fonction de la première valeur d'écart et de la deuxième valeur d'écart, la plaquette transportée (20) à se déplacer par rapport à la surface de prélèvement (301b), pour aligner la deuxième puce à lier (21) avec la première puce à lier (11) ; ou l'ensemble de liaison est en outre configuré pour entraîner, en fonction de la première valeur d'écart et de la deuxième valeur d'écart, la surface de prélèvement (301b) où la première puce à lier (11) est prélevée pour se déplacer par rapport à l'étage de plaquette (303), pour aligner la première puce à lier (11) avec la deuxième puce à lier (21) ;
l'ensemble de liaison est en outre configuré pour lier la première puce à lier (11) à la deuxième puce à lier (21).

2. Le système de liaison (300) selon la revendication 1, dans lequel
la tête de liaison (301) comprend une surface latérale perpendiculaire à la surface de prélèvement (301b), une surface supérieure parallèle à la surface de prélèvement (301b) et au moins trois marques d'étalonnage, dans lequel les au moins trois marques d'étalonnage sont situées sur la surface latérale ou la surface supérieure, et un plan sur lequel sont situées les au moins trois marques d'étalonnage est parallèle à la surface de prélèvement (301b) ;
le premier ensemble d'alignement (304) est spécifiquement configuré pour déterminer le décalage en fonction des sous-écarts entre les au moins trois marques d'étalonnage et une position prédéfinie.

3. Le système de liaison (300) selon la revendication 2, dans lequel
les au moins trois marques d'étalonnage comprennent une première marque d'étalonnage, une deuxième marque d'étalonnage, une troisième marque d'étalonnage,
le premier ensemble d'alignement (304) est spécifiquement configuré pour acquérir une première image comprenant la première marque d'étalonnage lorsque la tête de liaison (301) est située à la première position, et déterminer un premier sous-écart entre une position de la première marque d'étalonnage et la position prédéfinie en fonction de la première image ;
l'ensemble de liaison est en outre configuré pour entraîner la tête de liaison (301) en rotation d'un premier angle, pour permettre au premier ensemble d'alignement (304) d'acquérir une deuxième image comprenant la deuxième marque d'étalonnage ;
le premier ensemble d'alignement (304) est en outre spécifiquement configuré pour déterminer un deuxième sous-écart entre une position de la deuxième marque d'étalonnage et la position prédéfinie selon la deuxième image acquise ;
l'ensemble de liaison est en outre configuré pour entraîner la tête de liaison (301) en rotation d'un deuxième angle, pour permettre au premier ensemble d'alignement (304) d'acquérir une troisième image comprenant la troisième marque d'étalonnage ;
le premier ensemble d'alignement (304) est en outre spécifiquement configuré pour déterminer un troisième sous-écart entre une position de la troisième marque d'étalonnage et la position prédéfinie en fonction de la troisième image acquise, et déterminer le décalage en fonction du premier sous-écart, du deuxième sous-écart et du troisième sous-écart.

4. Le système de liaison (300) selon la revendication 2, dans lequel
le premier ensemble d'alignement (304) comprend au moins trois dispositifs d'alignement, chaque dispositif d'alignement étant configuré pour acquérir un sous-écart entre l'une des marques d'étalonnage et la position prédéfinie ;
le premier ensemble d'alignement (304) est spécifiquement configuré pour déterminer le décalage en fonction des au moins trois sous-écarts.

5. Le système de liaison (300) selon la revendication 1, dans lequel
la tête de liaison (301) comprend une surface latérale perpendiculaire à la surface de prélèvement (301b), et au moins deux chemins optiques d'étalonnage pénétrant dans la tête de liaison (301) à partir de la surface latérale, dans lequel un plan sur lequel se situent les au moins deux chemins optiques d'étalonnage est parallèle à la surface de prélèvement (301b) ;
le premier ensemble d'alignement (304) est spécifiquement configuré pour déterminer le décalage en fonction de sous-décalages entre les au moins deux chemins optiques d'étalonnage et le plan horizontal.

6. Le système de liaison (300) selon la revendication 5, dans lequel
les au moins deux chemins optiques d'étalonnage comprennent un premier chemin optique d'étalonnage et un deuxième chemin optique d'étalonnage,
le premier ensemble d'alignement (304) comprend une unité de transmission et une unité de réception,
dans lequel lorsque la tête de liaison (301) est située à la première position, l'unité de transmission est alignée avec une extrémité du premier chemin optique d'étalonnage, et l'unité de réception est alignée avec au moins une partie d'une zone d'une autre extrémité du premier chemin optique d'étalonnage ; l'unité de transmission est configurée pour transmettre un signal optique d'étalonnage à l'extrémité du premier chemin optique d'étalonnage ; l'unité de réception est configurée pour déterminer un premier sous-décalage en fonction d'un signal optique d'étalonnage reçu transmis par le biais du premier chemin optique d'étalonnage ;
l'ensemble de liaison est en outre configuré pour entraîner la tête de liaison (301) en rotation, pour permettre à une extrémité du deuxième chemin optique d'étalonnage d'être alignée avec l'unité de transmission, dans lequel l'unité de réception est alignée avec au moins une partie d'une zone d'une autre extrémité du deuxième chemin optique d'étalonnage ;
l'unité de transmission est en outre configurée pour transmettre un signal optique d'étalonnage à l'extrémité du deuxième chemin optique d'étalonnage ; l'unité de réception est en outre configurée pour déterminer un deuxième sous-décalage en fonction d'un signal optique d'étalonnage reçu transmis par le biais du deuxième chemin optique d'étalonnage ;
le premier ensemble d'alignement (304) est spécifiquement configuré pour déterminer le décalage en fonction du premier sous-décalage et du deuxième sous-décalage.

7. Le système de liaison (300) selon la revendication 5, dans lequel
le premier ensemble d'alignement (304) comprend une première unité de transmission et une deuxième unité de transmission, et une première unité de réception et une deuxième unité de réception,
les au moins deux chemins optiques d'étalonnage comprennent un premier chemin optique d'étalonnage et un deuxième chemin optique d'étalonnage,
dans lequel lorsque la tête de liaison (301) est située à la première position, la première unité de transmission est alignée avec une extrémité du premier chemin optique d'étalonnage, et la première unité de réception est alignée avec au moins une partie d'une zone d'une autre extrémité du premier chemin optique d'étalonnage ; une deuxième unité de transmission est alignée avec une extrémité du deuxième chemin optique d'étalonnage, et la deuxième unité de réception est alignée avec au moins une partie d'une zone d'une autre extrémité du deuxième chemin optique d'étalonnage ;
la première unité de transmission est configurée pour transmettre un signal optique d'étalonnage à l'extrémité du premier chemin optique d'étalonnage ;
la première unité de réception est configurée pour déterminer un premier sous-décalage en fonction d'un signal optique d'étalonnage reçu transmis par le biais du premier chemin optique d'étalonnage ;
la deuxième unité de transmission est configurée pour transmettre un signal optique d'étalonnage à l'extrémité du deuxième chemin optique d'étalonnage ;
la deuxième unité de réception est configurée pour déterminer un deuxième sous-décalage en fonction d'un signal optique d'étalonnage reçu transmis par le biais du deuxième chemin optique d'étalonnage ;
le premier ensemble d'alignement (304) est spécifiquement configuré pour déterminer le décalage en fonction du premier sous-décalage et du deuxième sous-décalage.

8. Un procédé de liaison, appliqué à la liaison d'une première puce à lier à une deuxième puce à lier sur une plaquette, **caractérisé en ce qu'**il comprend :
lorsqu'une tête de liaison prélevant la première puce à lier est située à une première position, la détermination (S100) d'un décalage d'une surface de prélèvement où la tête de liaison prélève la première puce à lier par rapport à un plan horizontal ;
l'entraînement (S200), en fonction du décalage, de la tête de liaison à se déplacer vers une deuxième position parallèle au plan horizontal ;
lorsque la tête de liaison est située à la deuxième position, la transmission d'un signal optique de détection, la réception d'un signal optique de réflexion généré par la première puce à lier réfléchissant le signal optique de détection, la détermination (S300), en fonction du signal optique de réflexion reçu, d'une première valeur d'écart entre une position actuelle de la première puce à lier prélevée et une première position cible, et la détermination d'une deuxième valeur d'écart entre une position actuelle de la deuxième puce à lier et une deuxième position cible ;
le déplacement (S400) de la plaquette ou de la première puce à lier en fonction de la première valeur d'écart et de la deuxième valeur d'écart, pour aligner la première puce à lier avec la deuxième puce à lier ; et
la liaison (S500) de la première puce à lier à la deuxième puce à lier, après avoir aligné la première puce à lier avec la deuxième puce à lier.

9. Le procédé de liaison selon la revendication 8, dans lequel la tête de liaison comprend une surface latérale perpendiculaire à la surface de prélèvement, une surface supérieure parallèle à la surface de prélèvement et au moins trois marques d'étalonnage, dans lequel les au moins trois marques d'étalonnage sont situées sur la surface latérale ou la surface supérieure et comprennent une première marque d'étalonnage, une deuxième marque d'étalonnage et une troisième marque d'étalonnage, et un plan sur lequel sont situées les au moins trois marques d'étalonnage est parallèle à la surface de prélèvement ;
la détermination du décalage de la surface de prélèvement de la tête de liaison par rapport au plan horizontal comprend :
l'acquisition d'une première image comprenant la première marque d'étalonnage ;
la détermination d'un premier sous-écart entre une position de la première marque d'étalonnage et la position prédéfinie en fonction de la première image ;
l'entraînement de la tête de liaison à tourner d'un premier angle après l'acquisition de la première image ;
l'acquisition d'une deuxième image comprenant le deuxième marque d'étalonnage après que la tête de liaison a tourné du premier angle ;
la détermination d'un deuxième sous-écart entre une position de la deuxième marque d'étalonnage et la position prédéfinie selon la deuxième image ;
l'entraînement de la tête de liaison à tourner d'un deuxième angle après l'acquisition de la deuxième image ;
l'acquisition d'une troisième image comprenant la troisième marque d'étalonnage après que la tête de liaison a tourné du deuxième angle ;
la détermination d'un troisième sous-écart entre une position de la troisième marque d'étalonnage et la position prédéfinie en fonction de la troisième image ; et
la détermination du décalage en fonction du premier sous-écart, du deuxième sous-écart et du troisième sous-écart.

10. Le procédé de liaison selon la revendication 8, dans lequel la tête de liaison comprend une surface latérale perpendiculaire à la surface de prélèvement, une surface supérieure parallèle à la surface de prélèvement et au moins trois marques d'étalonnage, dans lequel les au moins trois marques d'étalonnage sont situées sur la surface latérale ou la surface supérieure, et un plan sur lequel sont situées les au moins trois marques d'étalonnage est parallèle à la surface de prélèvement ;
la détermination du décalage de la surface de prélèvement de la tête de liaison par rapport au plan horizontal comprend :
l'acquisition simultanée de sous-écarts entre les au moins trois marques d'étalonnage et une position prédéfinie ; et
la détermination du décalage en fonction des au moins trois sous-écarts.

11. Le procédé de liaison selon la revendication 8, dans lequel la tête de liaison comprend une surface latérale perpendiculaire à la surface de prélèvement, et au moins deux chemins optiques d'étalonnage pénétrant dans la tête de liaison à partir de la surface latérale, dans lequel un plan sur lequel sont situés les au moins deux chemins optiques d'étalonnage est parallèle à la surface de prélèvement, les au moins deux chemins optiques d'étalonnage comprennent un premier chemin optique d'étalonnage et un deuxième chemin optique d'étalonnage ;
la détermination du décalage de la surface de prélèvement de la tête de liaison par rapport au plan horizontal comprend :
la transmission d'un signal optique d'étalonnage à une extrémité du premier chemin optique d'étalonnage ;
la détermination d'un premier sous-décalage en fonction d'un signal optique d'étalonnage reçu transmis par le biais du premier chemin optique d'étalonnage ;
l'entraînement de la tête de liaison à tourner après avoir déterminé le premier sous-décalage ;
la transmission d'un signal optique d'étalonnage à une extrémité du deuxième chemin optique d'étalonnage après la rotation de la tête de liaison ;
la détermination d'un deuxième sous-décalage en fonction d'un signal optique d'étalonnage reçu transmis par le biais du deuxième chemin optique d'étalonnage ; et
la détermination du décalage en fonction du premier sous-décalage et du deuxième sous-décalage.

12. Le procédé de liaison selon la revendication 8, dans lequel la tête de liaison comprend une surface latérale perpendiculaire à la surface de prélèvement, et au moins deux chemins optiques d'étalonnage pénétrant dans la tête de liaison à partir de la surface latérale, dans lequel un plan sur lequel sont situés les au moins deux chemins optiques d'étalonnage est parallèle à la surface de prélèvement, les au moins deux chemins optiques d'étalonnage comprennent un premier chemin optique d'étalonnage et un deuxième chemin optique d'étalonnage ;
la détermination du décalage de la surface de prélèvement de la tête de liaison par rapport au plan horizontal comprend :
la transmission d'un signal optique d'étalonnage à une extrémité du premier chemin optique d'étalonnage, et la transmission d'un signal optique d'étalonnage à une extrémité du deuxième chemin optique d'étalonnage ;
la détermination d'un premier sous-décalage en fonction d'un signal optique d'étalonnage reçu transmis par le biais du premier chemin optique d'étalonnage ;
la détermination d'un deuxième sous-décalage en fonction d'un signal optique d'étalonnage reçu transmis par le biais du deuxième chemin optique d'étalonnage ; et
la détermination du décalage en fonction du premier sous-décalage et du deuxième sous-décalage.
